# EUROPEAN PATENT APPLICATION

(11) **EP 4 676 201 A1**
(43) Date of publication of application: **07.01.2026**
(21) Application number: 25186021.9
(22) Date of filing: 27.06.2025
(51) Int. Cl.: H10K 59/122, H10K 59/123, H10K 59/80, H10K 59/131

(54) **ELECTRONIC DISPLAY DEVICE**

(30) Priority: 01.07.2024 KR 20240086001
(71) Applicant: Samsung Display Co., Ltd., Yongin-si, Gyeonggi-do 17113 (KR)
(72) Inventor: PARK, Juchan, 17113 Yongin-si (KR); KIM, Sunho, 17113 Yongin-si (KR); KO, Yoomin, 17113 Yongin-si (KR); CHOI, Chung Sock, 17113 Yongin-si (KR)
(74) Representative: Walaski, Jan Filip

(57) **Abstract**

An electronic device includes a pixel driving circuit including a transistor, a light emitting element including a first electrode, an intermediate layer disposed on the first electrode, and a second electrode disposed on the intermediate layer, a connection electrode electrically connecting the light emitting element and the pixel driving circuit and including a light emitting connection portion connected to the light emitting element and a driving connection portion connected to the pixel driving circuit, a pixel definition layer including a light emitting opening defined therethrough and overlapping a portion of the first electrode, and a protruding pattern disposed on the pixel definition layer. The protruding pattern includes a groove that extends from its upper surface in a thickness direction.

## Description

### CROSS-REFERENCE TO RELATED APPLICATION(S)

This application claims priority to Korean Patent Application No. 10-2024-0086001 filed on 1 July 2024 in the Korean Intellectual Property Office.

### 1. Technical Field

The present disclosure is directed to an electronic device. More particularly, the present disclosure is directed to an electronic device with enhanced contact reliability.

### 2. Discussion of Related Art

Multimedia electronic devices, such as televisions, mobile phones, tablet computers, computers, navigation devices, and game devices, include a display panel to display images. The display panel includes light emitting elements and circuits to drive the light emitting elements. When a voltage is supplied to these circuits, the light emitting elements activate to generate and display images.

A pixel driving circuit among the circuits controls the operation of the light emitting elements. For example, the pixel driving circuit may manage current flowing through each pixel to regulate the brightness and color output, ensuring that images are displayed with the correct luminance and chromaticity. A contact is present between the pixel driving circuit and the light-emitting elements. The contact is important for operational effectiveness of the display, as it allows the pixel driving circuit to deliver the necessary electrical signals to the light-emitting elements.

The reliability of this contact is significant because any inconsistency or failure in the connection can lead to display errors, such as non-uniform brightness, color inaccuracies, or visible defects in the display output. Thus, there is a need to increase the reliability of this contact.

### SUMMARY

At least one embodiment of the present disclosure provides an electronic device designed to enhance contact reliability between a driving circuit and light-emitting elements, thereby increasing image quality and reducing defects in multimedia display panels.

An embodiment of the inventive concept provides an electronic device including a pixel driving circuit, a light emitting element, a connection electrodes, a pixel definition layer and a protruding pattern. The pixel driving circuit includes a transistor. The light emitting element includes a first electrode, an intermediate layer disposed on the first electrode, and a second electrode disposed on the intermediate layer. The connection electrode electrically connects the light emitting element and the pixel driving circuit and includes a light emitting connection portion connected to the light emitting element and a driving connection portion connected to the pixel driving circuit. The pixel definition layer includes a light emitting opening defined therethrough and overlapping a portion of the first electrode. The protruding pattern is disposed on the pixel definition layer. The protruding pattern includes a groove that extends from an upper surface of the protruding pattern in a thickness direction of the protruding pattern.

The second electrode may be disconnected by the groove. For example, the groove may separate the second electrode into two distinct and electrically isolated parts.

The connection electrode may extend along an outer side surface and an upper surface of the protruding pattern.

The connection electrode may include a first edge and a second edge surrounding the first edge, where the second edge overlaps the groove of the protruding pattern when viewed in a plane.

The connection electrode may include a tip portion that extends from an end of the groove.

The groove may be defined by an inner lower surface of the protruding pattern, inner side surfaces extending from the inner lower surface, and a lower surface of the tip portion of the connection electrode.

In an embodiment, the intermediate layer includes a light emitting layer and a functional layer, the light emitting layer is disposed between the first electrode and the second electrode, and the functional layer includes a first intermediate functional layer disposed between the first electrode and the light emitting layer and a second intermediate functional layer disposed between the second electrode and the light emitting layer.

A portion of the functional layer may be disposed on the protruding pattern and cover the tip portion of the connection electrode.

The electronic device may further include a first dummy layer disposed in the groove of the protruding pattern, where the first dummy layer includes the same material as the functional layer and is formed through a same process as the functional layer.

The first dummy layer may be disposed on the inner lower surface of the protruding pattern.

The first dummy layer may be disposed on the inner lower surface of the protruding pattern and extend along the inner side surfaces of the protruding pattern.

The second electrode may be disposed on the functional layer at a position above the protruding pattern, where the second electrode covers a side surface of the functional layer.

The second electrode may cover the lower surface of the tip portion of the connection electrode.

The electronic device further may include a second dummy layer disposed in the groove of the protruding pattern, where the second dummy layer includes the same material as the second electrode and is formed through a same process as the second electrode.

The second dummy layer may be disposed on the first dummy layer and extend along the inner side surfaces of the protruding pattern.

The second electrode may be connected to the connection electrode on an outer side surface of the protruding pattern or in an area adjacent to the outer side surface of the protruding pattern.

The protruding pattern may have a reverse-tapered shape.

The electronic device may further include an intermediate connection electrode electrically connecting the pixel driving circuit and the connection electrode.

The pixel definition layer may include a through hole, where the connection electrode is connected to the intermediate connection electrode and the pixel driving circuit via the through hole.

Embodiments of the inventive concept provide an electronic device including a pixel driving circuit, a light emitting element, a connection electrode, a pixel definition layer and a protruding pattern. The pixel driving circuit includes a transistor. The light emitting element includes a first electrode, an intermediate layer disposed on the first electrode, and a second electrode disposed on the intermediate layer. The connection electrode is electrically connecting the light emitting element and the pixel driving circuit and includes a light emitting connection portion connected to the light emitting element and a driving connection portion connected to the pixel driving circuit. The pixel definition layer includes a light emitting opening defined therethrough and overlaps a portion of the first electrode. The protruding pattern is disposed on the pixel definition layer. The second electrode is electrically discontinuous at the protruding pattern.

The protruding pattern may include a groove extending from an upper surface of the protruding pattern in a thickness direction, when the groove overlaps an area where the second electrode is electrically discontinuous when viewed in a plane.

An embodiment of the inventive concept provides an electronic device including a pixel driving circuit, a light emitting element, a connection electrode and a protruding pattern. The pixel driving circuit includes a transistor. The light emitting element includes a first electrode, an intermediate layer disposed on the first electrode, and a second electrode disposed on the intermediate layer. The connection electrode electrically connects the light emitting element and the pixel driving circuit and includes a light emitting connection portion connected to the light emitting element and a driving connection portion connected to the pixel driving circuit. The protruding pattern includes a groove defined extending from an upper surface of the protruding pattern in a thickness direction of the protruding pattern. The connection electrode includes a tip portion extending from an end of the groove, where a portion of the intermediate layer covers the tip portion of the connection electrode, and the second electrode covers the intermediate layer above the protruding pattern.

According to the above, the light emitting element and the pixel driving circuit may be in stable contact with each other, and thus contact reliability may be increased. As an example, a cathode of the light emitting element and the connection electrode electrically connected to the pixel driving circuit may be connected to each other in a relatively wide area rather than being connected at a specific point, and thus, the contact reliability may be increased. Thus, defects in appearance caused by a contact failure, such as spots detected when the electronic device is lit, may be reduced or removed. As a result, the image quality and the production yield of the electronic device may be increased.

According to the above, as the groove is defined in the protruding pattern, the intermediate layer (or the functional layer) and the second electrode are formed after being separated for each pixel. Accordingly, a lateral leakage current is prevented from occurring between adjacent pixels, and thus, a color mixture between adjacent pixels and a brightness reduction are prevented.

### BRIEF DESCRIPTION OF THE DRAWINGS

The above features of the present disclosure will become readily apparent by reference to the following detailed description when considered in conjunction with the accompanying drawings wherein:
FIG. 1 is a block diagram of an electronic device;
FIGS. 2A to 2C are equivalent circuit diagrams of pixels;
FIGS. 3A and 3B are plan views of display panels;
FIGS. 4A to 4D are enlarged plan views of some areas of a display panel;
FIG. 5 is a cross-sectional view of a display panel; and
FIG. 6 is an enlarged cross-sectional view of an area of a display panel.

### DETAILED DESCRIPTION

In the present disclosure, it will be understood that when an element (or area, layer, or portion) is referred to as being "on", "connected to" or "coupled to" another element or layer, it can be directly on, connected or coupled to the other element or layer or intervening elements or layers may be present.

Like numerals refer to like elements throughout. As used herein, the term "and/or" may include any and all combinations of one or more of the associated listed items.

It will be understood that, although the terms first, second, etc. may be used herein to describe various elements, these elements are not limited by these terms. These terms are only used to distinguish one element from another element. Thus, a first element discussed below could be termed a second element without departing from the teachings of the present disclosure. As used herein, the singular forms, "a", "an" and "the" are intended to include the plural forms as well, unless the context clearly indicates otherwise.

Spatially relative terms, such as "beneath", "below", "lower", "above", "upper" and the like, may be used herein for ease of description to describe one element or feature's relationship to another elements or features as shown in the figures.

It will be further understood that the terms "include" and/or "including", when used in this specification, specify the presence of stated features, integers, steps, operations, elements, and/or components, but do not preclude the presence or addition of one or more other features, integers, steps, operations, elements, components, and/or groups thereof.

At least one embodiment is directed to an electronic device that enhances the reliability of electrical contact between a pixel driving circuit and light-emitting elements of a display panel of the display device. This may be achieved by incorporating a protruding pattern with a groove that separates a cathode for each pixel, preventing lateral leakage currents and reducing issues like color mixing and brightness reduction. Connection electrodes may be configured to extend along the side and upper surfaces of the protruding pattern, ensuring stable and reliable electrical connections. Additionally, dummy layers made from the same materials as the cathode may be formed within the groove to reinforce structural integrity. This design may increase the contact area, minimize display defects such as spots caused by poor connections, and enhance overall image quality and production yield for the display panel.

Hereinafter, embodiments will be described with reference to the accompanying drawings.

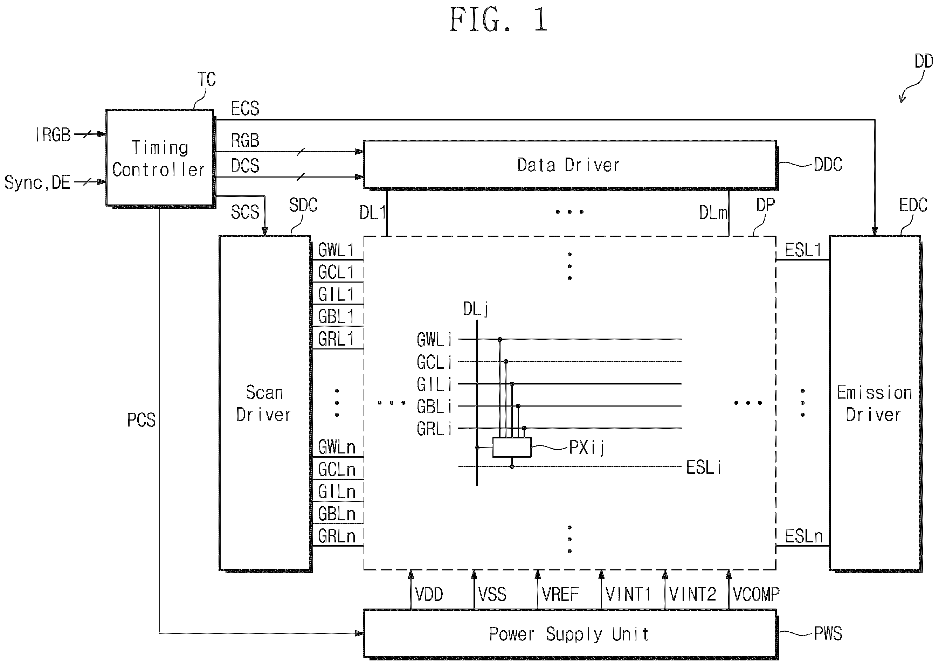

FIG. 1 is a block diagram of an electronic device DD.

Referring to FIG. 1, the electronic device DD may include a display panel DP, panel drivers SDC, EDC, and DDC (e.g., driver circuits), a power supply unit PWS (e.g., a power supply), and a timing controller TC (e.g., a controller circuit). The display panel DP may be a light-emitting type display panel. The light-emitting type display panel may be an organic light emitting display panel, an inorganic light emitting display panel, or a quantum dot light emitting display panel. Hereinafter, the organic light emitting display panel will be described as a representative example of the display panel DP. The panel drivers SDC, EDC, and DDC may include a scan driver SDC, an emission driver EDC, and a data driver DDC.

The display panel DP may include scan lines GWL1 to GWLn, GCL1 to GCLn, GIL1 to GILn, GBL1 to GBLn, and GRL1 to GRLn, emission lines ESL1 to ESLn, and data lines DL1 to DLm. The display panel DP may include a plurality of pixels connected to the scan lines GWL1 to GWLn, GCL1 to GCLn, GIL1 to GILn, GBL1 to GBLn, and GRL1 to GRLn, the emission lines ESL1 to ESLn, and the data lines DL1 to DLm. Each of "m" and "n" is an integer number greater than 1.

As an example, a pixel PXij (each of "i" and "j" is an integer number greater than 1) positioned to correspond to an i-th horizontal line (or an i-th pixel row) and a j-th vertical line (or a j-th pixel column) may be connected to an i-th first scan line (or a write scan line) GWLi, an i-th second scan line (or a compensation scan line) GCLi, an i-th third scan line (or a first initialization scan line) GILi, an i-th fourth scan line (or a second initialization scan line) GBLi, an i-th fifth scan line (or a reset scan line) GRLi, a j-th data line DLj, and an i-th emission line ESLi.

The pixel PXij may include a plurality of light emitting elements, a plurality of transistors, and a plurality of capacitors. The pixel PXij may receive a first power voltage VDD, a second power voltage VSS, a third power voltage (or a reference voltage) VREF, a fourth power voltage (or a first initialization voltage) VINT1, a fifth power voltage (or a second initialization voltage) VINT2, and a sixth power voltage (or a compensation voltage) VCOMP from the power supply unit PWS.

The first power voltage VDD and the second power voltage VSS may have a voltage value set to allow a current to flow through the light emitting element, and thus light may be emitted from the light emitting element. As an example, the first power voltage VDD may be set to have a voltage level higher than that of the second power voltage VSS.

The third power voltage VREF may be a voltage to initialize a gate of a driving transistor included in the pixel PXij. The third power voltage VREF may be used to implement a predetermined grayscale using a difference in voltage between the third power voltage VREF and a data signal. To this end, the third power voltage VREF may be set to a predetermined voltage within a voltage range of the data signal.

The fourth power voltage VINT1 may be used to initialize the capacitor included in the pixel PXij. The fourth power voltage VINT1 may be set to a voltage level lower than that of the third power voltage VREF. As an example, the fourth power voltage VINT1 may be set to a voltage level lower than a difference between the third power voltage VREF and a threshold voltage of the driving transistor, but is not limited thereto.

The fifth power voltage VINT2 may be used to initialize a cathode of the light emitting element included in the pixel PXij. The fifth power voltage VINT2 may be set to a voltage level lower than the first power voltage VDD or the fourth power voltage VINT1 or may be set to a voltage level similar to or the same as the third power voltage VREF, but is not limited thereto or thereby. The fifth power voltage VINT2 may be set to a voltage level similar to or the same as the first power voltage VDD.

The sixth power voltage VCOMP may provide a predetermined current to the driving transistor when the threshold voltage of the driving transistor is compensated for.

Meanwhile, FIG. 1 shows a structure in which all the first, second, third, fourth, fifth, and sixth power voltages VDD, VSS, VREF, VINT1, VINT2, and VCOMP are provided from the power supply unit PWS. However, the present disclosure is not limited thereto. For example, both of the first power voltage VDD and the second power voltage VSS may be provided independently of the structure of the pixel PXij, while at least one of the third power voltage VREF, the fourth power voltage VINT1, the fifth power voltage VINT2, and the sixth power voltage VCOMP might not be provided depending on the structure of the pixel PXij.

Signal lines connected to the pixel PXij may be designed in various ways by taking into account the structure of the pixel PXij.

The scan driver SDC may receive a first control signal SCS from the timing controller TC and may provide a scan signal to the first scan lines GWL1 to GWLn, the second scan lines GCL1 to GCLn, the third scan lines GIL1 to GILn, the fourth scan lines GBL1 to GBLn, and the fifth scan lines GRL1 to GRLn in response to the first control signal SCS.

The scan signal may be set to a voltage that allows the transistors to be turned on in response to the scan signal. For example, the scan signal provided to a P-type transistor may be set to a logic low level, and the scan signal provided to an N-type transistor may be set to a logic high level. Hereinafter, the expression "The scan signal is provided" may refer to the application of the scan signal to a transistor at a logic level that turns on the transistor.

For the convenience of explanation, FIG. 1 shows one scan driver SDC, however, the present disclosure is not limited thereto. The electronic device DD may include multiple scan drivers to provide the scan signal to the first scan lines GWL1 to GWLn, the second scan lines GCL1 to GCLn, the third scan lines GIL1 to GILn, the fourth scan lines GBL1 to GBLn, and the fifth scan lines GRL1 to GRLn.

The emission driver EDC may provide emission signals to the emission lines ESL1 to ESLn in response to a second control signal ECS. As an example, the emission signals may be sequentially provided to the emission lines ESL1 to ESLn.

Each transistor connected to the emission lines ESL1 to ESLn may be an N-type transistor. In this case, the emission signals provided to the emission lines ESL1 to ESLn may have a gate-on voltage. The transistors receiving the emission signal may be turned on when receiving the emission signal and may be turned off in other cases.

The second control signal ECS may include an emission start signal and clock signals. The emission driver EDC may be implemented by a shift register that uses clock signal to sequentially shift the emission start signal in pulse form, thereby generating and emitting a corresponding emission signal, also in pulse form, in a sequential manner.

The data driver DDC may receive a third control signal DCS and image data RGB from the timing controller TC. The data driver DDC may convert the image data RGB in a digital form to analog data signals. The data driver DDC may provide the data signal to the data lines DL1 to DLm in response to the third control signal DCS.

The third control signal DCS may include a data enable signal, a horizontal start signal, and a data clock signal to indicate an output of an effective data signal. As an example, the data driver DDC may include a shift register that aligns the horizontal start signal with the data clock signal to generate a sampling signal. This setup may include a latch that latches the image data RGB in response to the sampling signal, a digital-to-analog converter (or a decoder) that converts the latched digital image data into analog data signals, and buffers (or amplifiers) that output these analog data signals to the data lines DL1 to DLm.

The power supply unit PWS may provide the first power voltage VDD, the second power voltage VSS, and the third power voltage VREF to the display panel DP to drive the pixel PXij. In addition, the power supply unit PWS may provide at least one voltage of the fourth power voltage VINT1, the fifth power voltage VINT2, and the sixth power voltage VCOMP to the display panel DP.

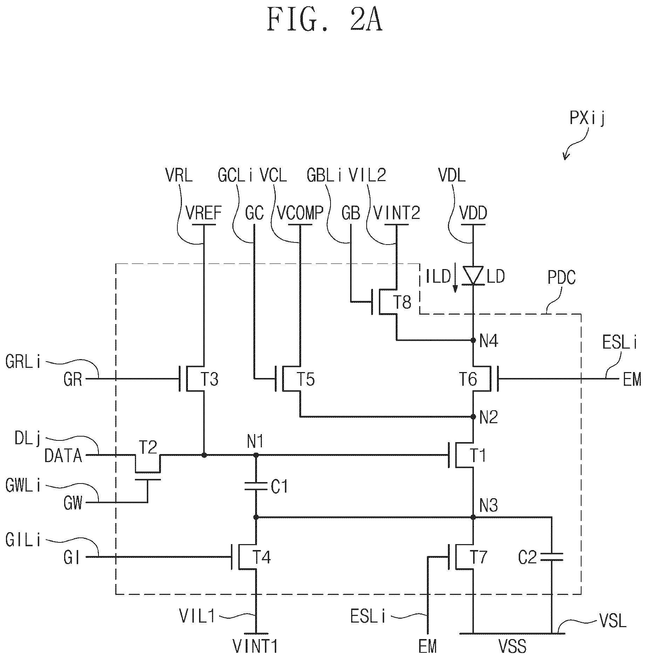

For example, the power supply unit PWS may provide the first power voltage VDD, the second power voltage VSS, the third power voltage VREF, the fourth power voltage VINT1, the fifth power voltage VINT2, and the sixth power voltage VCOMP to the display panel DP respectively via a first power line VDL (refer to FIG. 2A), a second power line VSL (refer to FIG. 2A), a third power line (or a reference voltage line) VRL (refer to FIG. 2A), a fourth power line (or a first initialization voltage line) VIL1 (refer to FIG. 2A), a fifth power line (or a second initialization voltage line) VIL2 (refer to FIG. 2A), and a sixth power line (or a compensation voltage line) VCL (refer to FIG. 2A), which are not shown in FIG. 1.

The power supply unit PWS may be implemented by a power management integrated circuit (IC), but is not limited thereto.

The timing controller TC may generate the first control signal SCS, the second control signal ECS, the third control signal DCS, and a fourth control signal PCS based on input image data IRGB, a synchronization signal Sync, e.g., a vertical synchronization signal, a horizontal synchronization signal, etc., the data enable signal DE, and a clock signal. The first control signal SCS may be applied to the scan driver SDC, the second control signal ECS may be applied to the emission driver EDC, the third control signal DCS may be applied to the data driver DDC, and the fourth control signal PCS may be applied to the power supply unit PWS. The timing controller TC may rearrange the input image data IRGB to correspond to an arrangement of the pixel PXij in the display panel DP and may generate the image data RGB (or frame data).

Meanwhile, the scan driver SDC, the emission driver EDC, the data driver DDC, the power supply unit PWS, and/or the timing controller TC may be directly formed in the display panel DP or may be connected to the display panel DP after being manufactured in a separate driving chip. In addition, at least two of the scan driver SDC, the emission driver EDC, the data driver DDC, the power supply unit PWS, and the timing controller TC may be provided in a single driving chip. As an example, the data driver DDC and the timing controller TC may be provided in a single driving chip.

Although the electronic device DD is described with reference to FIG. 1 in the above description, the electronic device DD is not limited thereto. For example, signal lines may be added or omitted depending on the structure of the pixels. In addition, a connection relationship between one pixel and the signal lines may be changed. In the case where one of the signal lines is omitted, the omitted signal line may be replaced with another signal line.

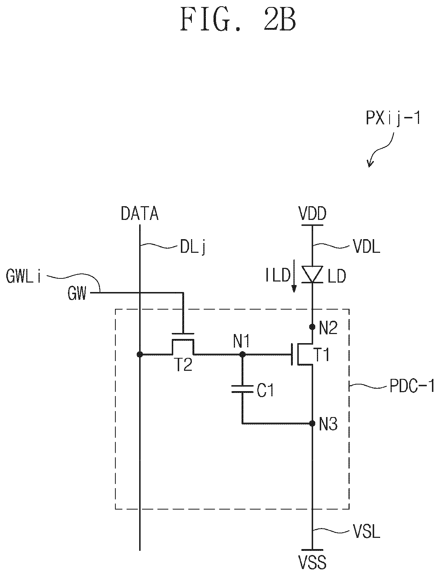

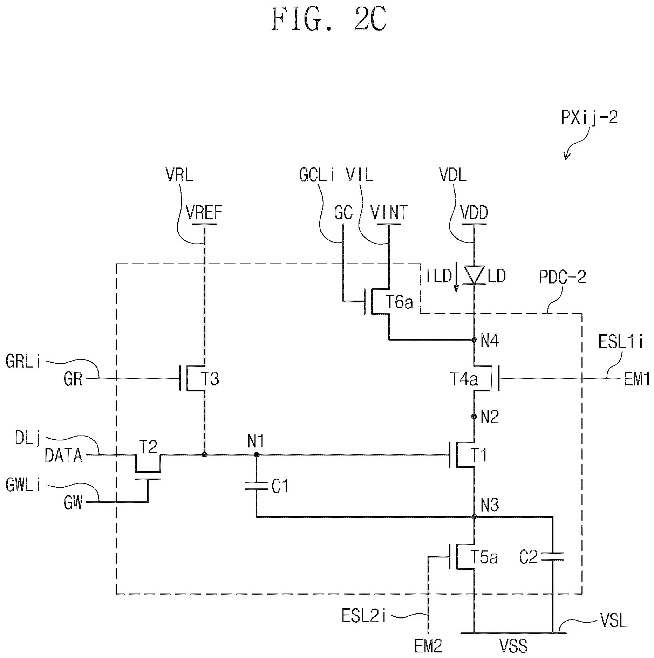

FIGS. 2A, 2B, and 2C are equivalent circuit diagrams of pixels. FIGS. 2A, 2B, and 2C show the equivalent circuit diagrams of pixels PXij, PXij-1, and PXij-2, which are connected to the i-th first scan line GWLi (hereinafter, referred to as a write scan line) and the j-th data line DLj (hereinafter, referred to as a data line).

Referring to FIG. 2A, the pixel PXij may include a light emitting element LD and a pixel driving circuit PDC. The light emitting element LD may be connected to the first power line VDL and the pixel driving circuit PDC.

The pixel driving circuit PDC may be connected to the scan lines GWLi, GCLi, GILi, GBLi, and GRLi, the data line DLj, the emission line ESLi, and the power lines VDL, VSL, VIL1, VIL2, VRL, and VCL. The pixel driving circuit PDC may include first, second, third, fourth, fifth, sixth, seventh, and eighth transistors T1, T2, T3, T4, T5, T6, T7, and T8, a first capacitor C1, and a second capacitor C2. Hereinafter, each of the first, second, third, fourth, fifth, sixth, seventh, and eighth transistors T1, T2, T3, T4, T5, T6, T7, and T8 will be described as the N-type transistor, but is not limited thereto. Some of the first to eighth transistors T1 to T8 may be N-type transistors, and the others of the first to eighth transistors T1 to T8 may be P-type transistors, or each of the first to eighth transistors T1 to T8 may be P-type transistors, but they are not limited thereto.

A gate of the first transistor T1 may be connected to a first node N1. A first electrode of the first transistor T1 may be connected to a second node N2, and a second electrode of the first transistor T1 may be connected to a third node N3. The first transistor T1 may be a driving transistor. The first transistor T1 may control a driving current ILD flowing from the first power line VDL to the second power line VSL via the light emitting element LD in response to a voltage of the first node N1. In this case, the first power voltage VDD may be set to a voltage with an electric potential higher than the second power voltage VSS.

In the present disclosure, the expression "A transistor is connected to a signal line" may refer to the configuration where one of a source electrode, a drain electrode, and a gate electrode of the transistor is either integrated with the signal line or connected to the signal line via a connection electrode. In addition, the expression "A transistor is electrically connected to another transistor" may refer to the configuration where one of a source electrode, a drain electrode, and a gate electrode of the transistor is either integrated with one of a source electrode, a drain electrode, and a gate electrode of another transistor or connected to one of the source electrode, the drain electrode, and the gate electrode of the other transistor via a connection electrode.

The second transistor T2 may include a gate connected to the write scan line GWLi, a first electrode connected to the data line DLj, and a second electrode connected to the first node N1. The second transistor T2 may provide a data signal DATA to the first node N1 in response to a write scan signal GW applied thereto via the write scan line GWLi. The second transistor T2 may be turned on when the write scan signal GW is applied thereto via the write scan line GWLi, and thus, the data line DLj may be electrically connected to the first node N1.

The third transistor T3 may be connected between the first node N1 and the reference voltage line VRL. A first electrode of the third transistor T3 may receive the reference voltage VREF via the reference voltage line VRL, and a second electrode of the third transistor T3 may be connected to the first node N1. In the present embodiment, a gate of the third transistor T3 may receive a reset scan signal GR via the i-th fifth scan line GRLi (hereinafter, referred to as a reset scan line). The third transistor T3 may be turned on when the reset scan signal GR is applied thereto via the reset scan line GRLi and may provide the reference voltage VREF to the first node N1.

The fourth transistor T4 may be connected between the third node N3 and the first initialization voltage line VIL1. A first electrode of the fourth transistor T4 may be connected to the third node N3, and a second electrode of the fourth transistor T4 may be connected to the first initialization voltage line VIL1 through which the first initialization voltage VINT1 is provided. The fourth transistor T4 may be referred to as a first initialization transistor. A gate of the fourth transistor T4 may receive a first initialization scan signal GI via the i-th third scan line GILi (hereinafter, referred to as a first initialization scan line). The fourth transistor T4 may be turned on when the first initialization scan signal GI is provided thereto via the first initialization scan line GILi and may provide the first initialization voltage VINT1 to the third node N3.

The fifth transistor T5 may be connected between the compensation voltage line VCL and the second node N2. A first electrode of the fifth transistor T5 may receive the compensation voltage VCOMP via the compensation voltage line VCL, and a second electrode of the fifth transistor T5 may be connected to the second node N2 to be electrically connected to the first electrode of the first transistor T1. A gate of the fifth transistor T5 may receive a compensation scan signal GC via the i-th second scan line GCLi (hereinafter, referred to as a compensation scan line). The fifth transistor T5 may be turned on when the compensation scan signal GC is provided thereto via the compensation scan line GCLi and may provide the compensation voltage VCOMP to the second node N2. Thus, the threshold voltage of the first transistor T1 may be compensated for during a compensation period.

The sixth transistor T6 may be connected between the first transistor T1 and the light emitting element LD. In detail, a gate of the sixth transistor T6 may receive an emission signal EM via the i-th emission line ESLi (hereinafter, referred to as an emission line). A first electrode of the sixth transistor T6 may be connected to the cathode of the light emitting element LD via a fourth node N4, and a second electrode of the sixth transistor T6 may be connected to the first electrode of the first transistor T1 via the second node N2. The sixth transistor T6 may be referred to as a first emission control transistor. The sixth transistor T6 may be turned on when the emission signal EM is provided thereto via the emission line ESLi. Thus, the light emitting element LD may be electrically connected to the first transistor T1.

The seventh transistor T7 may be connected between the second power line VSL and the third node N3. A first electrode of the seventh transistor T7 may be connected to the second electrode of the first transistor T1 via the third node N3, and a second electrode of the seventh transistor T7 may receive the second power voltage VSS via the second power line VSL. A gate of the seventh transistor T7 may be electrically connected to the emission line ESLi. The seventh transistor T7 may be referred to as a second emission control transistor. The seventh transistor T7 may be turned on when the emission signal EM is provided thereto via the emission line ESLi, Thus, the second electrode of the first transistor T1 may be electrically connected to the second power line VSL.

According to the present example, the sixth transistor T6 and the seventh transistor T7 are connected to the same emission line ESLi and may be turned on in response to the same emission signal EM, however, this is merely an example. The sixth transistor T6 and the seventh transistor T7 may be independently turned on in response to distinct and separate signals. In addition, one of the sixth transistor T6 and the seventh transistor T7 may be omitted from the pixel driving circuit PDC.

The eighth transistor T8 may be connected between the second initialization voltage line VIL2 and the fourth node N4. That is, the eighth transistor T8 may include a gate connected to the i-th fourth scan line GBLi (hereinafter, referred to as a second initialization scan line), a first electrode connected to the second initialization voltage line VIL2, and a second electrode connected to the fourth node N4. The eighth transistor T8 may be referred to as a second initialization transistor. The eighth transistor T8 may provide the second initialization voltage VINT2 to the fourth node N4 corresponding to the cathode of the light emitting element LD in response to a second initialization scan signal GB applied thereto via the second initialization scan line GBLi. The cathode of the light emitting element LD may be initialized by the second initialization voltage VINT2.

Some of the second, third, fourth, fifth, sixth, seventh, and eighth transistors T2, T3, T4, T5, T6, T7, and T8 may be substantially simultaneously turned on in response to the same scan signal. As an example, the eighth transistor T8 and the fifth transistor T5 may be substantially simultaneously turned on in response to the same scan signal. As an example, the eighth transistor T8 and the fifth transistor T5 may be operated in response to the same compensation scan signal GC. The eighth transistor T8 and the fifth transistor T5 may be substantially simultaneously turned on and off in response to the same compensation scan signal GC. In this case, the compensation scan line GCLi and the second initialization scan line GBLi may be provided by a single scan line. Accordingly, the initialization of the cathode of the light emitting element LD and the compensation of the threshold voltage of the first transistor T1 may be performed with the same timing. However, the present disclosure is not limited thereto.

In addition, the initialization of the cathode of the light emitting element LD and the compensation of the threshold voltage of the first transistor T1 may be performed in response to the same power voltage. As an example, the compensation voltage line VCL and the second initialization voltage line VIL2 may be provided by a single power line. In this case, the initialization operation of the cathode and the compensation operation of the driving transistor may be performed using one power voltage, and thus, a design for the drivers may be simplified. However, this is merely an example, and the present disclosure is not limited thereto.

The first capacitor C1 may be disposed between the first node N1 and the third node N3. The first capacitor C1 may be charged with a voltage corresponding to a difference between the voltage of the first node N1 and the voltage of the third node N3. The first capacitor C1 may be referred to as a storage capacitor.

The second capacitor C2 may be disposed between the third node N3 and the second power line VSL. That is, one electrode of the second capacitor C2 may be connected to the second power line VSL receiving the second power voltage VSS, and the other electrode of the second capacitor C2 may be connected to the third node N3. The second capacitor C2 may be charged with electric charges corresponding to a difference in voltage between the second power voltage VSS and the third node N3. The second capacitor C2 may be referred to as a hold capacitor. The second capacitor C2 may have a higher storage capacity compared with the first capacitor C1. Accordingly, the second capacitor C2 may reduce a variation in voltage of the third node N3 according to a variation in voltage of the first node N1.

The light emitting element LD may be connected to the pixel driving circuit PDC via the fourth node N4. The light emitting element LD may include an anode connected to the first power line VDL and a cathode opposite to the anode. The light emitting element LD may be connected to the pixel driving circuit PDC through the cathode thereof. That is, according to the pixel PXij, a connection node at which the light emitting element LD is connected to the pixel driving circuit PDC may be the fourth node N4. The fourth node N4 may correspond to a connection node between the first electrode of the sixth transistor T6 and the cathode of the light emitting element LD. Accordingly, an electric potential of the fourth node N4 may correspond to an electric potential of the cathode of the light emitting element LD.

In detail, the anode of the light emitting element LD may be connected to the first power line VDL. The first power voltage VDD that is a constant voltage may be applied to the anode, and the cathode may be electrically connected to the first transistor T1 via the sixth transistor T6. That is, in the present example in which each of the first to eighth transistors T1 to T8 is an N-type transistor, an electric potential of the third node N3 corresponding to a source of the first transistor T1 may not be directly affected by characteristics of the light emitting element LD. Accordingly, despite any deterioration in the characteristics of the light emitting element LD, the impact of this deterioration on a gate-source voltage (Vgs) of the transistors within the pixel driving circuit PDC, especially the driving transistor, may be minimized. That is, since a change in an amount of the driving current due to the deterioration in characteristics of the light emitting element LD may be reduced, an image retention defect of the display panel caused by the increase in usage time may be reduced, and a lifespan of the display panel may be increased.

As shown in FIG. 2B, the pixel PXij-1 may include a pixel driving circuit PDC-1 including two transistors T1 and T2 and one first capacitor C1. The pixel driving circuit PDC-1 may be connected to a light emitting element LD, a write scan line GWLi, a data line DLj, and a second power line VSL. The pixel driving circuit PDC-1 shown in FIG. 2B may have a circuit configuration corresponding to a circuit configuration obtained by removing the third to eighth transistors T3 to T8 and the second capacitor C2 from the pixel driving circuit PDC shown in FIG. 2A.

Each of the first and second transistors T1 and T2 may be an N-type transistor or a P-type transistor. In the present example, each of the first and second transistors T1 and T2 will be described as the N-type transistor.

The first transistor T1 may include a gate connected to a first node N1, a first electrode connected to a second node N2, and a second electrode connected to a third node N3. The second node N2 may be connected to a first power line VDL, and the third node N3 may be connected to the second power line VSL. The first transistor T1 may be connected to the light emitting element LD via the second node N2 and may be connected to the second power line VSL via the third node N3. The first transistor T1 may be a driving transistor.

The second transistor T2 may include a gate receiving a write scan signal GW via the write scan line GWLi, a first electrode connected to the data line DLj, and a second electrode connected to the first node N1. The second transistor T2 may provide a data signal DATA to the first node N1 in response to the write scan signal GW applied thereto via the write scan line GWLi.

The first capacitor C1 may include an electrode connected to the first node N1 and an electrode connected to the third node N3. The first capacitor C1 may be charged with the data signal DATA applied to the first node N1.

The light emitting element LD may include an anode and a cathode. The anode of the light emitting element LD may be connected to the first power line VDL, and the cathode of the light emitting element LD may be connected to the pixel driving circuit PDC-1 via the second node N2. The cathode of the light emitting element LD may be connected to the first transistor T1. The light emitting element LD may emit light in response to an amount of current flowing through the first transistor T1 of the pixel driving circuit PDC-1.

In the present example in which each of the first and second transistors T1 and T2 is an N-type transistor, the second node N2 at which the cathode of the light emitting element LD is connected to the pixel driving circuit PDC-1 may correspond to a drain of the first transistor T1. That is, a variation of a gate-source voltage (Vgs) of the first transistor T1 caused by the light emitting element LD may be prevented. Accordingly, the change in the amount of driving current due to deterioration of the light emitting element LD may be reduced, the image retention defect of a display panel caused by the increase in usage time may be reduced, and the lifespan of the display panel may be increased.

Referring to FIG. 2C, the pixel PXij-2 may include a pixel driving circuit PDC-2 that includes six transistors T1, T2, T3, T4a, T5a, and T6a and two capacitors C1 and C2.

The pixel driving circuit PDC-2 may be connected to a light emitting element LD, a write scan line GWLi, a reset scan line GRLi, a compensation scan line GCLi, an i-th first emission line ESL1i (hereinafter, referred to as a first emission line), an i-th second emission line ESL2i (hereinafter, referred to as a second emission line), a data line DLj, a first power line VDL, a second power line VSL, a reference voltage line VRL, and an initialization voltage line VIL.

The pixel driving circuit PDC-2 shown in FIG. 2C may have a circuit configuration similar to a circuit configuration obtained by removing the fourth transistor T4 and the fifth transistor T5 from the pixel driving circuit PDC shown in FIG. 2A. Since the pixel driving circuit PDC-2 shown in FIG. 2C has an area smaller than an area of the pixel driving circuit PDC shown in FIG. 2A, high resolution may be implemented more easily.

Each of first, second, third, fourth, fifth, and sixth transistors T1, T2, T3, T4a, T5a, and T6a may be an N-type or P-type transistor. In the present example, each of the first, second, third, fourth, fifth, and sixth transistors T1, T2, T3, T4a, T5a, and T6a will be described as an N-type transistor as a representative example.

The first transistor T1 may include a gate connected to a first node N1, a first electrode connected to a second node N2, and a second electrode connected to a third node N3. The second node N2 may be connected to the first power line VDL, and the third node N3 may be connected to the second power line VSL. The first transistor T1 may be connected to the light emitting element LD via the second node N2 and may be connected to the second power line VSL via the third node N3. The first transistor T1 may be a driving transistor.

The second transistor T2 may include a gate receiving a write scan signal GW via the write scan line GWLi, a first electrode connected to the data line DLj, and a second electrode connected to the first node N1. The second transistor T2 may provide a data signal DATA to the first node N1 in response to the write scan signal GW applied thereto via the write scan line GWLi.

The third transistor T3 may be connected between the first node N1 and the reference voltage line VRL. A first electrode of the third transistor T3 may receive a reference voltage VREF via the reference voltage line VRL, and a second electrode of the third transistor T3 may be connected to the first node N1. A gate of the third transistor T3 may receive a reset scan signal GR via the reset scan line GRLi. The third transistor T3 may be turned on when the reset scan signal GR is applied thereto via the reset scan line GRLi to provide the reference voltage VREF to the first node N1.

The fourth transistor T4a may be connected between the first transistor T1 and the light emitting element LD. In detail, a gate of the fourth transistor T4a may receive a first emission signal EM1 via the first emission line ESL1i. A first electrode of the fourth transistor T4a may be connected to a cathode of the light emitting element LD via a fourth node N4, and a second electrode of the fourth transistor T4a may be connected to the first electrode of the first transistor T1 via the second node N2. The fourth transistor T4a may be referred to as a first emission control transistor. The fourth transistor T4a may be turned on when the first emission signal EM1 is applied thereto via the first emission line ESL1i. Thus, the light emitting element LD may be electrically connected to the first transistor T1.

The fifth transistor T5a may be connected between the second power line VSL and the third node N3. A first electrode of the fifth transistor T5a may be connected to the second electrode of the first transistor T1 via the third node N3, and a second electrode of the fifth transistor T5a may receive a second power voltage VSS via the second power line VSL. A gate of the fifth transistor T5a may be electrically connected to the second emission line ESL2i. The fifth transistor T5a may be referred to as a second emission control transistor. The fifth transistor T5a may be turned on when a second emission signal EM2 is applied thereto via the second emission line ESL2i. Thus, the second electrode of the first transistor T1 may be electrically connected to the second power line VSL.

In the present example, the fourth transistor T4a and the fifth transistor T5a are respectively connected to distinct first and second emission lines ESL1i and ESL2i. They activate (or turn on) in response to separate first and second emission signals EM1 and EM2, respectively. That is, the fourth transistor T4a and the fifth transistor T5a may be independently turned on, however, this is merely an example. As an example, the fourth transistor T4a and the fifth transistor T5a may be connected to the same emission line and may be controlled by the same emission signal. In addition, one of the fourth transistor T4a and the fifth transistor T5a may be omitted from the pixel driving circuit PDC-2.

The sixth transistor T6a may be connected between the initialization voltage line VIL and the fourth node N4. That is, the sixth transistor T6a may include a gate connected to the compensation scan line GCLi, a first electrode connected to the initialization voltage line VIL, and a second electrode connected to the fourth node N4. The sixth transistor T6a may be referred to as an initialization transistor. The sixth transistor T6a may provide an initialization voltage VINT to the fourth node N4 corresponding to the cathode of the light emitting element LD in response to a compensation scan signal GC applied thereto via the compensation scan line GCLi. The cathode of the light emitting element LD may be initialized by the initialization voltage VINT.

A first capacitor C1 may be disposed between the first node N1 and the third node N3. The first capacitor C1 may be charged with a voltage corresponding to a difference between a voltage of the first node N1 and a voltage of the third node N3. The first capacitor C1 may be referred to as a storage capacitor.

A second capacitor C2 may be disposed between the third node N3 and the second power line VSL. That is, one electrode of the second capacitor C2 may be connected to the second power line VSL to which the second power voltage VSS is applied, and the other electrode of the second capacitor C2 may be connected to the third node N3. The second capacitor C2 may be charged with electric charges corresponding to a difference in voltage between the second power voltage VSS and the third node N3. The second capacitor C2 may be referred to as a hold capacitor.

The light emitting element LD may include an anode and the cathode. The anode of the light emitting element LD may be connected to the first power line VDL, and the cathode of the light emitting element LD may be connected to the pixel driving circuit PDC-2 via the fourth node N4. The cathode of the light emitting element LD may be connected to the first transistor T1 via the fourth transistor T4a. The light emitting element LD may emit light in response to an amount of current flowing through the first transistor T1 of the pixel driving circuit PDC-2.

In the present example in which each of the first, second, third, fourth, fifth, and sixth transistors T1, T2, T3, T4a, T5a, and T6a is an N-type transistor, an electric potential of the third node N3 corresponding to a source of the first transistor T1, which is the driving transistor, may not be directly affected by characteristics of the light emitting element LD. Accordingly, despite deterioration in the light emitting element LD, the impact of this deterioration on the gate-source voltage (Vgs) of the transistors within the pixel driving circuit PDC-2, especially the driving transistor, may be minimized. That is, since a change in an amount of a driving current due to the deterioration of the light emitting element LD may be reduced, an image retention defect of the display panel caused by the increase in usage time may be reduced, and a lifespan of the display panel may be increased.

While, FIGS. 2A, 2B, and 2C show circuits of the pixel driving circuits PDC, PDC-1, and PDC-2, the number and arrangement of the transistors and the number and arrangement of the capacitors may be designed in various ways as long as the circuits are connected to the cathode of the light emitting element LD in the display panel.

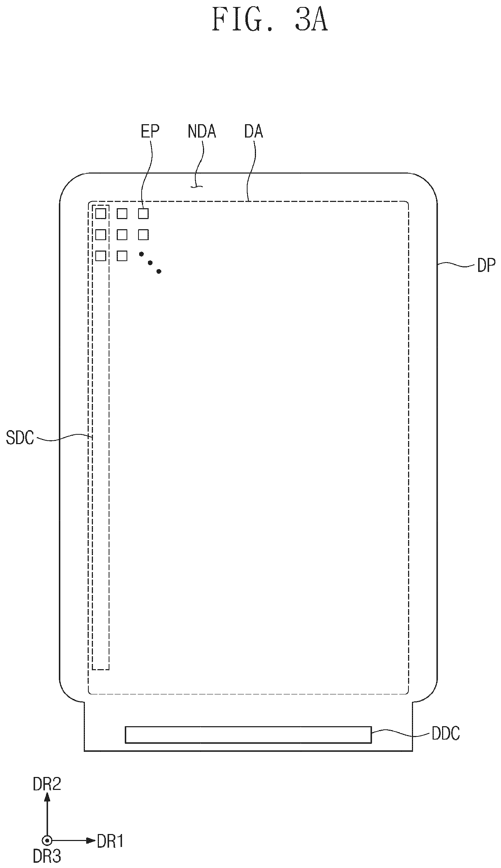

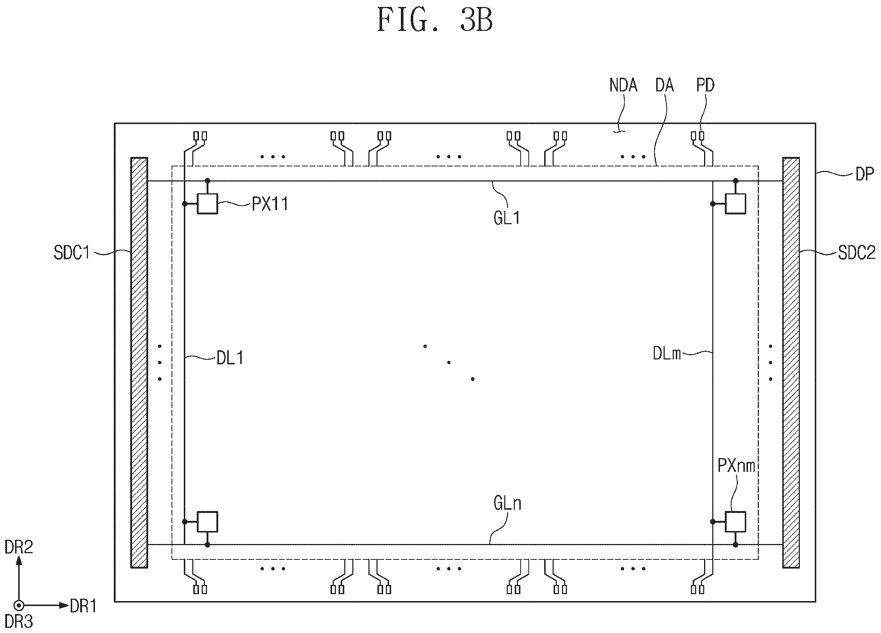

FIGS. 3A and 3B are plan views of display panels. For the convenience of explanation, some components are omitted in each of FIGS. 3A and 3B.

Referring to FIG. 3A, the display panel DP may include a display area DA and a peripheral area (or a non-display area) NDA. The display area DA may include a plurality of light emitting portions EP.

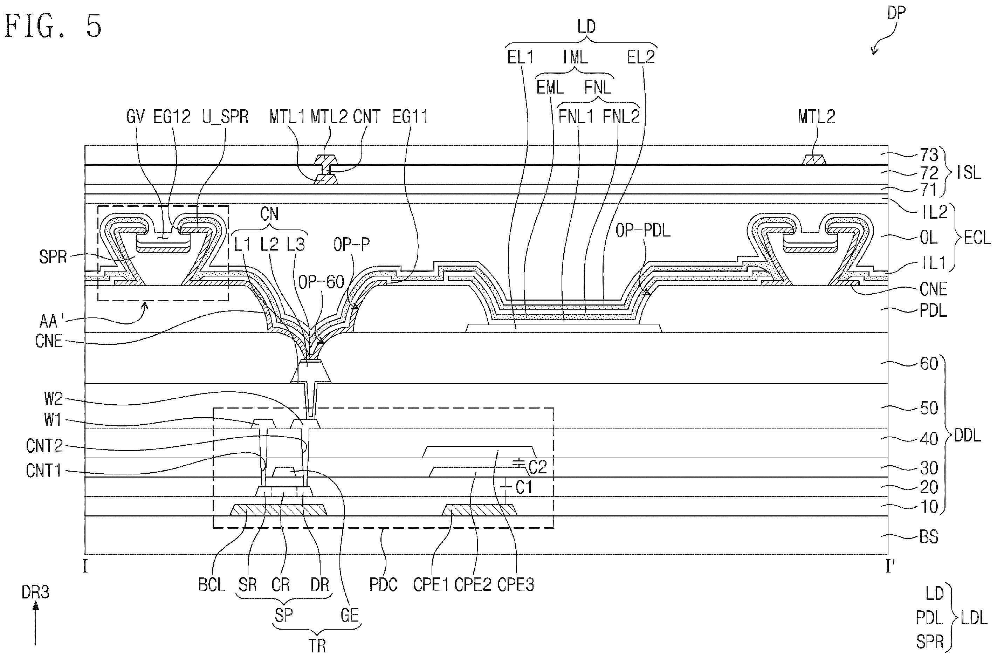

The light emitting portions EP may be areas where the pixels PXij (refer to FIG. 1) emit the light. In detail, each of the light emitting portions EP may correspond to a light emitting opening OP-PDL (refer to FIG. 5) described later.

The peripheral area NDA may be adjacent to the display area DA. The peripheral area NDA may have a shape surrounding an edge of the display area DA, however, this is merely an example. The peripheral area NDA may be adjacent to one side of the display area DA or may be omitted.

A scan driver SDC and a data driver DDC may be mounted on the display panel DP. The scan driver SDC may be disposed in the display area DA, and the data driver DDC may be disposed in the peripheral area NDA. The scan driver SDC may overlap at least some of the light emitting portions EP arranged in the display area DA when viewed in a plane or from above. When the scan driver SDC is disposed in the display area DA, a size of the peripheral area NDA may be reduced compared with a conventional display panel in which a scan driver is disposed in a peripheral area, and thus, a narrow bezel of the electronic device may be easily implemented.

Meanwhile, different from the scan driver SDC shown in FIG. 3A, the scan driver SDC may be provided in two separate parts. The two scan drivers SDC may be respectively disposed at left and right sides of the display area DA and may be spaced apart from each other. Three or more scan drivers SDC may be employed, but the number of the scan drivers SDC is not limited thereto.

FIG. 3A shows a representative example of the display panel, and the data driver DDC may be disposed in the display area DA. In the case where the data driver DDC is disposed in the display area DA, some of the light emitting portions EP arranged in the display area DA may overlap the data driver DDC when viewed in a plane or from above.

The data driver DDC may be provided in a separate driving chip independently formed from the display panel DP and may be connected to the display panel DP, however, this is merely an example. The data driver DDC may be formed through the same process as the scan driver SDC to form the display panel DP, but is not limited thereto.

Referring to FIG. 3B, the display panel DP may have a length in a first direction DR1, which is longer than a length in a second direction DR2. The display panel DP may include a plurality of pixels PX11 to PXnm arranged in the display area DA in n rows by m columns. The display panel DP may include a plurality of scan drivers SDC1 and SDC2. The scan drivers SDC1 and SDC2 may include a first scan driver SDC1 and a second scan driver SDC2, which are spaced apart from each other in the first direction DR1.

The first scan driver SDC1 may be connected to some scan lines of scan lines GL1 to GLn, and the second scan driver SDC2 may be connected to the other scan lines among the scan lines GL1 to GLn. As an example, the first scan driver SDC1 may be connected to odd-numbered scan lines among the scan lines GL1 to GLn, and the second scan driver SDC2 may be connected to even-numbered scan lines among the scan lines GL1 to GLn.

For the convenience of explanation, FIG. 3B shows pads PD of data lines DL1 to DLm. The pads PD may be placed at ends of the data lines DL1 to DLm. The data lines DL1 to DLm may be connected to a data driver (refer to DDC of FIG. 3A) via the pads PD.

The pads PD may be arranged in areas of the peripheral area NDA, which are spaced apart from each other with the display area DA interposed therebetween. As an example, some pads among the pads PD may be arranged in an upper portion of the display panel DP, which is adjacent to a first scan line GL1 among the scan lines GL1 to GLn, and the other pads among the pads PD may be arranged in a lower portion of the display panel DP, which is adjacent to the last scan line GLn among the scan lines GL1 to GLn. Pads which are connected to odd-numbered data lines among the pads PD may be arranged in the upper portion, and pads which are connected to even-numbered data lines among the pads PD may be arranged in the lower portion.

The display panel DP may include a plurality of upper data drivers connected to the pads PD arranged in the upper portion and a plurality of lower data drivers connected to the pads PD arranged in the lower portion, however, these are merely examples. The display panel DP may include one upper data driver connected to the pads arranged in the upper portion and/or one lower data driver connected to the pads arranged in the lower portion. The pads PD may be arranged only in one side portion and may be connected to a single data driver, but the present disclosure is not limited thereto.

In addition, as described with reference to FIG. 3A, the scan driver and/or the data driver of the display panel DP of FIG. 3B may be disposed in the display area DA, and thus, some of the light emitting portions arranged in the display area DA may overlap the scan driver and/or the data driver when viewed from overhead.

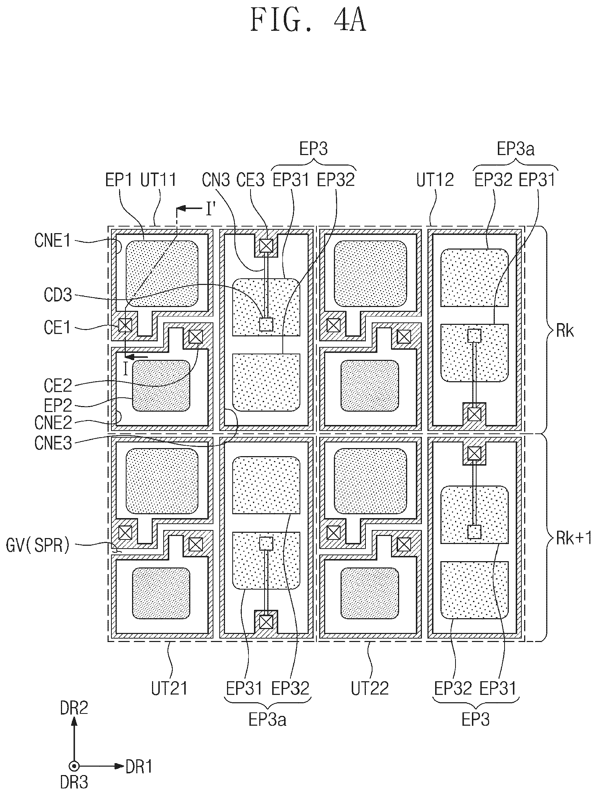

FIGS. 4A to 4D are enlarged plan views of some areas of the display panel DP.

FIG. 4A shows light emitting units UT11, UT12, UT21, and UT22 arranged in two rows by two columns. Referring to FIG. 4A, light emitting portions arranged in a first row Rk may include light emitting portions constituting the light emitting unit UT11 arranged in the first row and a first column and the light emitting unit UT12 arranged in the first row and a second column, and light emitting portions arranged in a second row Rk+1 may include light emitting portions constituting the light emitting unit UT21 arranged in the second row and the first column and the light emitting unit UT22 arranged in the second row and the second column.

Each of light emitting portions EP1, EP2, and EP3 may correspond to the light emitting opening OP-PDL (refer to FIG. 5) described later. That is, each of the light emitting portions EP1, EP2, and EP3 may be an area from which the light is emitted by the light emitting element. The light emitting portions EP1, EP2, and EP3 may correspond to a unit providing an image displayed through the display panel DP (refer to FIG. 1). In more detail, each of the light emitting portions EP1, EP2, and EP3 may correspond to an area defined by the light emitting opening OP-PDL described later, in particular, an area defined by a lower surface of the light emitting opening OP-PDL.

The light emitting portions EP1, EP2, and EP3 may include a first light emitting portion EP1, a second light emitting portion EP2, and a third light emitting portion EP3. The first light emitting portion EP1, the second light emitting portion EP2, and the third light emitting portion EP3 may emit light in distinct colors from one another. As an example, the first light emitting portion EP1 may emit red light, the second light emitting portion EP2 may emit green light, and the third light emitting portion EP3 may emit blue light. However, the combination of colors of the first, second, and third light emitting portions EP1, EP2, and EP3 is not limited thereto. In addition, at least two of the light emitting portions EP1, EP2, and EP3 may emit light having the same color. For instance, all the first, second, and third light emitting portions EP1, EP2, and EP3 may emit blue light or white light.

Among the first, second, and third light emitting portions EP1, EP2, and EP3, the third light emitting portion EP3 in which the image corresponding to the light emitted by a third light emitting element is displayed may include two sub-light emitting portions EP31 and EP32 spaced apart from each other in the second direction DR2. However, this is merely an example. The third light emitting portion EP3 may be provided as a single pattern formed as a single body like the first and second light emitting portions EP1 and EP2, or at least one of the first and second light emitting portions EP1 and EP2 may include sub-light emitting portions spaced apart from each other, but the present disclosure is not limited thereto.

The light emitting portions arranged in the first row Rk may include first, second, and third light emitting portions EP1, EP2, and EP3 constituting the light emitting unit UT11 arranged in the first row and the first column and first, second, and third light emitting portions EP1, EP2, and EP3a constituting the light emitting unit UT12 arranged in the first row and the second column. The light emitting portions arranged in the second row Rk+1 may include first, second, and third light emitting portions EP1, EP2, and EP3a constituting the light emitting unit UT21 arranged in the second row and the first column and first, second, and third light emitting portions EP1, EP2, and EP3 constituting the light emitting unit UT22 arranged in the second row and the second column.

The light emitting portions constituting the light emitting unit UT11 arranged in the first row and the first column may have substantially the same shape as the light emitting portions constituting the light emitting unit UT22 arranged in the second row and the second column. In addition, the light emitting portions constituting the light emitting unit UT12 arranged in the first row and the second column may have substantially the same shape as the light emitting portions constituting the light emitting unit UT21 arranged in the second row and the first column. The light emitting portions constituting the light emitting unit UT11 arranged in the first row and the first column may have a shape different from the shape of the light emitting portions constituting the light emitting unit UT12 arranged in the first row and the second column. As an example, some of the light emitting portions arranged in the first row Rk may have a symmetrical shape with respect to a shape of some of the light emitting portions arranged in the second row Rk+1.

The third light emitting portion EP3a of the light emitting unit UT21 arranged in the second row and the first column and the third light emitting portion EP3 of the light emitting unit UT11 arranged in the first row and the first column may have a line-symmetrical shape and an arrangement with respect to an axis substantially parallel to the first direction DR1. The third light emitting portion EP3 of the light emitting unit UT22 arranged in the second row and the second column and the third light emitting portion EP3a of the light emitting unit UT12 arranged in the first row and the second column may have a line-symmetrical shape and arrangement with respect to the axis substantially parallel to the first direction DR1. However, the present disclosure is not limited thereto.

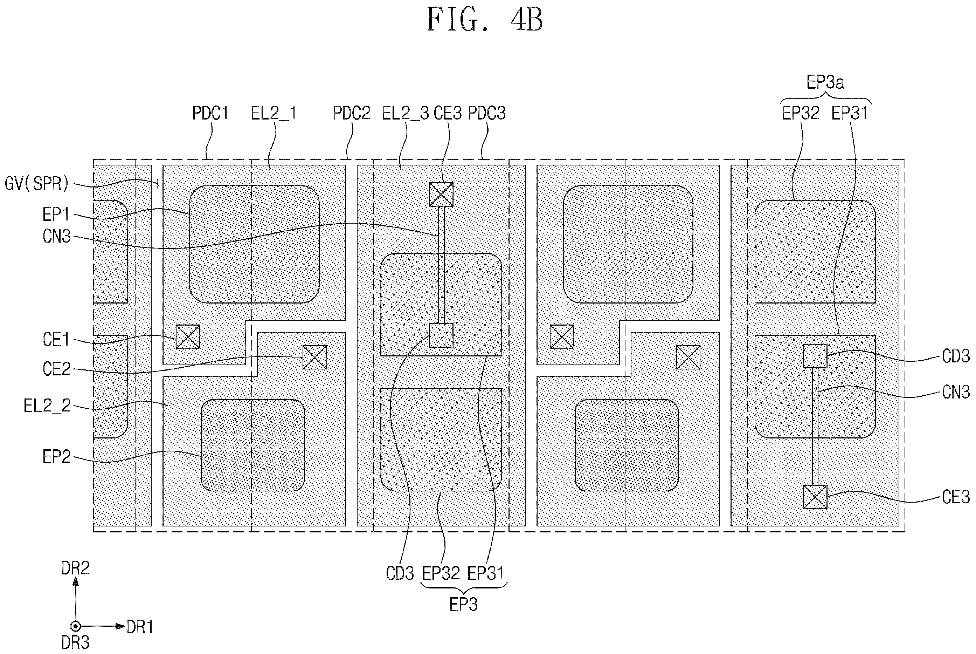

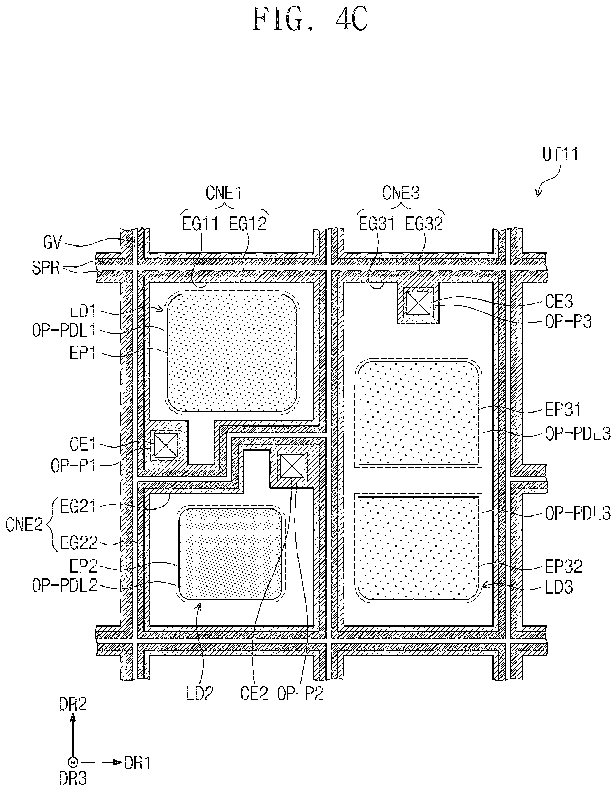

FIG. 4B shows the light emitting portions arranged in one row. For the convenience of explanation, FIG. 4B shows a plurality of second electrodes EL2_1, EL2_2, and EL2_3, a plurality of pixel driving circuits PDC1, PDC2, and PDC3, and a groove GV defined by a protruding pattern SPR. FIG. 4C shows the protruding pattern SPR, the groove GV defined by the protruding pattern SPR, the light emitting portions EP1, EP2, and EP3 disposed in areas defined by the groove GV, and a plurality of connection electrodes CNE1, CNE2, and CNE3 among components of the display panel. For example, the groove GV may be a depression in a surface of the protruding pattern SPR.

Referring to FIGS. 4B and 4C, the second electrodes EL2_1, EL2_2, and EL2_3 may be separated from each other by the groove GV and may be electrically disconnected from each other. In the present embodiment, one light emitting unit UT11 may include three light emitting portions EP1, EP2, and EP3. Accordingly, the light emitting unit UT11 may include three second electrodes EL2_1, EL2_2, and EL2_3 (hereinafter, referred to as first, second, and third cathodes), three pixel driving circuits PDC1, PDC2, and PDC3, and three connection electrodes CNE1, CNE2, and CNE3, however, this is merely an example. The configuration and quantity of the light emitting portions included in the light emitting unit UT11 may be varied in numerous ways. Accordingly, the present disclosure is not intended to be specifically limited to any particular design or arrangement..

First, second, and third pixel driving circuits PDC1, PDC2, and PDC3 may be respectively electrically connected to first, second, and third light emitting elements LD1, LD2, and LD3 including the first, second, and third light emitting portions EP1, EP2, and EP3. In the present disclosure, the expression that a component A is connected to a component B may mean not only a case where the component A is directly and physically connected to the component B, but also a case where the component A is electrically connected to the component B.

In addition, as shown in FIG. 4B, the regions defined for the first, second, and third pixel driving circuits PDC1, PDC2, and PDC3, when viewed from overhead, may correspond to units including transistors and capacitors constituting the pixel driving circuit PDC (refer to FIG. 2A). These units are designed to drive the light emitting elements of the pixels and are repeatedly arranged.

The first, second, and third pixel driving circuits PDC1, PDC2, and PDC3 may be sequentially arranged in the first direction DR1. The arrangement positions of the first, second, and third pixel driving circuits PDC1, PDC2, and PDC3 may be designed independently from positions and shapes of the first, second, and third light emitting portions EP1, EP2, and EP3.

As an example, the first, second, and third pixel driving circuits PDC1, PDC2, and PDC3 may be placed at positions different from the positions at which the first, second, and third cathodes EL2_1, EL2_2, and EL2_3 are placed in FIG. 4B, or may be designed to have shapes and sizes different from the shapes and sizes of the first, second, and third cathodes EL2_1, EL2_2, and EL2_3 illustrated in FIG. 4B. The first, second, and third pixel driving circuits PDC1, PDC2, and PDC3 may be placed to respectively overlap the positions at which the first, second, and third light emitting portions EP1, EP2, and EP3 are placed and may be designed to have shapes and sizes similar to those of the areas divided by the groove GV, i.e., shapes and sizes of the first, second, and third cathodes EL2_1, EL2_2, and EL2_3.

Each of the first, second, and third pixel driving circuits PDC1, PDC2, and PDC3 may have a rectangular shape, each of the first, second, and third light emitting portions EP1, EP2, and EP3 may have a size smaller than and a shape different from those of the first, second, and third pixel driving circuits PDC1, PDC2, and PDC3, and the first, second, and third cathodes EL2_1, EL2_2, and EL2_3 may be placed at positions overlapping the first, second, and third light emitting portions EP1, EP2, and EP3 and may have an atypical shape.

Accordingly, as shown in FIG. 4B, the first pixel driving circuit PDC1 may be placed at a position overlapping the first light emitting portion EP1, the second light emitting portion EP2, and a portion of another light emitting unit adjacent thereto. The second pixel driving circuit PDC2 may be placed at a position overlapping the first light emitting portion EP1, the second light emitting portion EP2, and the third cathode EL2_3. The third pixel driving circuit PDC3 may be placed at a position overlapping the third light emitting portion EP3, however, these are merely examples. The arrangement positions of the first, second, and third pixel driving circuits PDC1, PDC2, and PDC3 may be designed independently from the positions and shapes of the light emitting portions EP1, EP2, and EP3 but is not limited thereto.

Referring to FIGS. 4B and 4C again, the light emitting unit UT11 may include the first, second, and third connection electrodes CNE1, CNE2, and CNE3. The first connection electrode CNE1 may electrically connect the first light emitting element LD1 in which the first light emitting portion EP1 is formed (or the first light emitting portion EP1 is defined) and the first pixel driving circuit PDC1. The second connection electrode CNE2 may electrically connect the second light emitting element LD2 in which the second light emitting portion EP2 is formed and the second pixel driving circuit PDC2. The third connection electrode CNE3 may electrically connect the third light emitting element LD3 in which the third light emitting portion EP3 is formed and the third pixel driving circuit PDC3.

In detail, the first, second, and third connection electrodes CNE1, CNE2, and CNE3 may electrically connect the first, second, and third cathodes EL2_1, EL2_2, and EL2_3 and the first, second, and third pixel driving circuits PDC1, PDC2, and PDC3 in a one-to-one correspondence.

Each of the first, second, and third connection electrodes CNE1, CNE2, and CNE3 may be disposed on a pixel definition layer PDL (refer to FIG. 5) described later. In an embodiment, each of the first, second, and third connection electrodes CNE1, CNE2, and CNE3 have a ring shape to surround a corresponding light emitting portion among the first, second, and third light emitting portions EP1, EP2, and EP3. In the present embodiment, each of the first, second, and third connection electrodes CNE1, CNE2, and CNE3 may have a closed ring shape as a representative example, but is not limited thereto. As an example, at least one of the first, second, and third connection electrodes CNE1, CNE2, and CNE3 may have an open ring shape of which a portion is cut. For example, when the portion is cut, it may result in a non-continuous ring that does not completely enclose an area, resembling a 'C' or a horseshoe shape.

Since the first, second, and third connection electrodes CNE1, CNE2, and CNE3 are ring-shaped, the degree of freedom in connection positions, where the first, second, and third connection electrodes CNE1, CNE2, and CNE3 are connected to the first, second, and third pixel driving circuits PDC1, PDC2, and PDC3, may be increased. As an example, the first connection electrode CNE1 may be connected to the first pixel driving circuit PDC1 via a first connection portion CE1, the second connection electrode CNE2 may be connected to the second pixel driving circuit PDC2 via a second connection portion CE2, and the third connection electrode CNE3 may be connected to the third pixel driving circuit PDC3 via a connection line CN3. That is, connection lines additionally connected to the first and second connection electrodes CNE1 and CNE2 may be omitted. The first connection portion CE1, the second connection portion CE2, and the third connection portion CE3 may be referred to as a light emitting connection portion.

One connection line CN3 may electrically connect the third pixel driving circuit PDC3 and the third light emitting element LD3 including the third light emitting portion EP3. In detail, the connection line CN3 may correspond to the node (refer to the fourth node N4 of FIG. 2A, the second node N2 of FIG. 2B, or the fourth node N4 of FIG. 2C) at which the light emitting element LD (refer to FIG. 2A) is connected to the pixel driving circuit PDC of FIG. 2A, PDC-1 of FIG. 2B, or PDC-2 of FIG. 2C.

The connection line CN3 may include the third connection portion CE3 and a driving connection portion CD3. The third connection portion CE3 may be provided at one end of the connection line CN3, and the driving connection portion CD3 may be provided at the other end of the connection line CN3.

The driving connection portion CD3 may be a portion of the connection line CN3, which is connected to the third pixel driving circuit PDC3. The driving connection portion CD3 may be connected to an electrode of the transistor of the third pixel driving circuit PDC3. In detail, the driving connection portion CD3 may be connected to the drain of the sixth transistor T6 shown in FIG. 2A, the drain of the first transistor T1 shown in FIG. 2B, or the drain of the fourth transistor T4 shown in FIG. 2C. Accordingly, a position of the driving connection portion CD3 may correspond to a position of the transistor of the pixel driving circuit, which is physically connected to the connection line CN3. The third connection portion CE3 may be a portion of the connection line CN3, which is connected to the third light emitting element LD3. The third connection portion CE3 may be connected to the third connection electrode CNE3.

As shown in FIG. 4C, the first connection electrode CNE1 may include a first edge EG11 surrounding at least a portion of the first light emitting portion EP1 and a second edge EG12 surrounding the first edge EG11. The second connection electrode CNE2 may include a first edge EG21 surrounding at least a portion of the second light emitting portion EP2 and a second edge EG22 surrounding the first edge EG21. The third connection electrode CNE3 may include a first edge EG31 surrounding at least a portion of the third light emitting portion EP3 and a second edge EG32 surrounding the first edge EG31.

The first, second, and third connection electrodes CNE1, CNE2, and CNE3 are arranged spaced apart from each other. As an example, areas between the connection electrodes adjacent to each other among the first, second, and third connection electrodes CNE1, CNE2, and CNE3 may overlap the groove GV. As an example, the first edges EG11, EG21, and EG31 of the first, second, and third connection electrodes CNE1, CNE2, and CNE3 do not overlap the groove GV, while the second edges EG12, EG22, and EG32 of the first, second, and third connection electrodes CNE1, CNE2, and CNE3 overlap the groove GV.

The first, second, and third connection portions CE1, CE2, and CE3 may be disposed at positions that do not overlap the first, second, and third light emitting portions EP1, EP2, and EP3 when viewed from overhead. As an example, the light emitting opening OP-PDL (refer to FIG. 5) and through holes OP-P (refer to FIG. 5) spaced apart from the light emitting opening OP-PDL may be defined through the pixel definition layer PDL.

The through holes OP-P may include a first through hole OP-P1, a second through hole OP-P2, and a third through hole OP-P3. The first, second, and third connection portions CE1, CE2, and CE3 may be arranged corresponding to the first, second, and third through holes OP-P1, OP-P2, and OP-P3, respectively. The light emitting opening OP-PDL may include a first light emitting opening OP-PDL1, a second light emitting opening OP-PDL2, and a third light emitting opening OP-PDL3. The first, second, and third light emitting portions EP1, EP2, and EP3 may be defined to correspond to the first, second, and third light emitting openings OP-PDL1, OP-PDL2, and OP-PDL3, respectively. Accordingly, the first, second, and third connection portions CE1, CE2, and CE3 may be arranged at positions spaced apart from the first, second, and third light emitting portions EP1, EP2, and EP3.

The first, second, and third connection electrodes CNE1, CNE2, and CNE3 may be disposed on the pixel definition layer PDL (refer to FIG. 5). When viewed from overhead, the first connection electrode CNE1 may surround the first light emitting opening OP-PDL1, the second connection electrode CNE2 may surround the second light emitting opening OP-PDL2, and the third connection electrode CNE3 may surround the third light emitting openings OP-PDL3.

The driving connection portion CD3, which is the portion of the connection line CN3 where a transistor TR (refer to FIG. 5) of the third pixel driving circuit PDC3 is connected to the connection line CN3, may be defined at a position that does not overlap the third connection portion CE3 when viewed from overhead and may be disposed at a position overlapping the third light emitting portion EP3. Since the third cathode EL2_3 is connected to the pixel driving circuit PDC3 via the connection line CN3, restrictions on the design of the pixel driving circuit PDC3 due to the position or shape of the third light emitting portion EP3 may be reduced, and the degree of freedom in circuit design may be increased.

The first, second, and third cathodes EL2_1, EL2_2, and EL2_3 may be connected to the first, second, and third connection electrodes CNE1, CNE2, and CNE3. For example, the first, second, and third cathodes EL2_1, EL2_2, and EL2_3 may be connected to the first, second, and third connection electrodes CNE1, CNE2, and CNE3, respectively, in areas adjacent to the protruding pattern SPR.

In addition, the connection areas in which the first, second, and third cathodes EL2_1, EL2_2, and EL2_3 are connected to the first, second, and third connection electrodes CNE1, CNE2, and CNE3 may surround at least a portion of the first, second, and third light emitting openings OP-PDL1, OP-PDL2, and OP-PDL3, respectively. The first, second, and third cathodes EL2_1, EL2_2, and EL2_3 may be connected to the first, second, and third connection electrodes CNE1, CNE2, and CNE3 on an outer side surface of the protruding pattern SPR and in areas adjacent to the outer side surface of the protruding pattern SPR. That is, the first, second, and third cathodes EL2_1, EL2_2, and EL2_3 may be connected to the first, second, and third connection electrodes CNE1, CNE2, and CNE3 over a relatively large area, for example, at an area having a shape similar to each of the first, second, and third connection electrodes CNE1, CNE2, and CNE3 instead of being connected to the first, second, and third connection electrodes CNE1, CNE2, and CNE3 at specific points. That is, a size of the connection area may increase. Thus, a connection between the first, second, and third cathodes EL2_1, EL2_2, and EL2_3 and the first, second, and third connection electrodes CNE1, CNE2, and CNE3 may be stable.

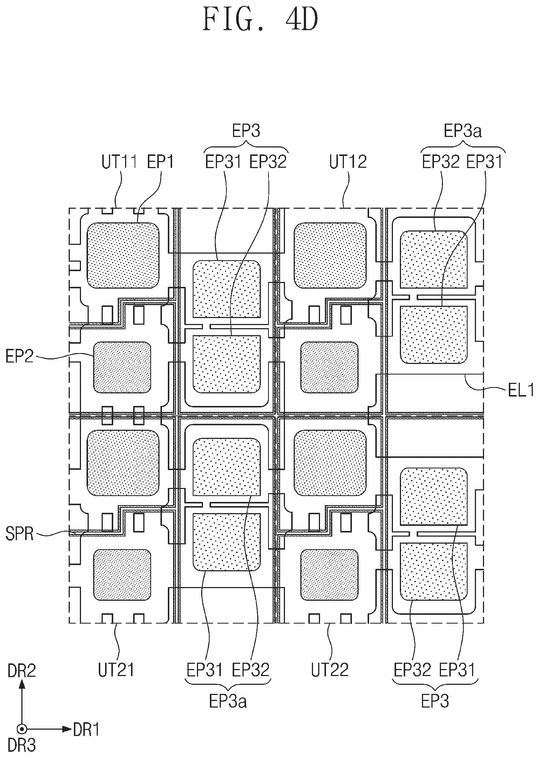

FIG. 4D shows the groove GV, the light emitting portions EP1, EP2, and EP3, and a first electrode EL1.

Referring to FIG. 4D, the first electrode EL1 (hereinafter, referred to as an anode) of the light emitting element LD (refer to FIG. 5) may be commonly disposed in the light emitting portions EP1, EP2, and EP3. That is, the anode EL1 may have a single body layer over the display area DA. Thus, the anode EL1 may overlap the groove GV. According to an embodiment, anodes EL1 of the light emitting elements LD may be formed as conductive patterns independent from each other and may be electrically connected to each other via other conductive layers, and thus, some of the anodes EL1 may be disposed not to overlap the groove GV.

As described above, the first power voltage VDD (refer to FIG. 2A) may be applied to the anode EL1, and a common voltage may be applied to all the light emitting portions. The anode EL1 may be connected to the first power line VDL (refer to FIG. 2A) providing the first power voltage VDD in the peripheral area NDA or may be connected to the first power line VDL (refer to FIG. 2A) in the display area DA, but is not limited thereto.

Meanwhile, openings may be defined through the anode EL1, and the openings may penetrate through the anode EL1. The openings defined through the anode EL1 may be defined not to overlap the light emitting portions EP (refer to FIG. 3A) and may be defined to substantially overlap the groove GV. The openings may facilitate a discharge of gas generated from an organic layer disposed under the anode EL1, e.g., a sixth insulating layer 60 (refer to FIG. 5). Accordingly, as the gas from the organic layer disposed under the light emitting element is sufficiently discharged in a manufacturing process of the display panel DP, the gas generated from the organic layer after the manufacturing process is over may be reduced. Thus, the rate of deterioration of the light emitting element may decrease.

FIG. 5 is a cross-sectional view of the display panel DP. FIG. 5 shows a cross-section taken along line I-I' of FIG. 4A.

Referring to FIG. 5, the display panel DP may include a base layer BS (e.g., a substrate), a driving element layer DDL, a light emitting element layer LDL, an encapsulation layer ECL, and a sensing layer ISL, however, this is merely an example. The display panel DP does not include the sensing layer ISL. For example, the sensing layer ISL may be omitted.

The driving element layer DDL may include a plurality of insulating layers 10, 20, 30, 40, 50, and 60 disposed on the base layer BS, a plurality of conductive patterns and a plurality of semiconductor patterns, which are disposed between the insulating layers. The conductive patterns and the semiconductor patterns disposed between the insulating layers 10, 20, 30, 40, 50, and 60 may form the pixel driving circuit PDC. For the convenience of explanation, FIG. 5 shows a cross-section of a portion of an area in which one light emitting portion is disposed.

The base layer BS may provide a base surface on which the pixel driving circuit PDC is disposed. The base layer BS may be a rigid substrate or a flexible substrate that is bendable, foldable, or rollable. The base layer BS may be a glass substrate, a metal substrate, or a polymer substrate, but is not limited thereto. The base layer BS may be an inorganic layer, an organic layer, or a composite material layer.

The base layer BS may have a multi-layer structure. The base layer BS may include a first polymer resin layer, a silicon oxide (SiOₓ) layer disposed on the first polymer resin layer, an amorphous silicon (a-Si) layer disposed on the silicon oxide layer, and a second polymer resin layer disposed on the amorphous silicon (a-Si) layer. The silicon oxide (SiOₓ) layer and the amorphous silicon (a-Si) layer may be referred to as a base barrier layer.

Each of the first and second polymer resin layers may include a polyimide-based resin. In addition, each of the first and second polymer resin layers may include at least one of an acrylic-based resin, a methacrylic-based resin, a polyisoprene-based resin, a vinyl-based resin, an epoxy-based resin, a urethane-based resin, a cellulose-based resin, a siloxane-based resin, a polyamide-based resin, and a perylene-based resin. Meanwhile, in the present disclosure, the term "X-based resin", as used herein, refers to the resin that includes a functional group of X.

Insulating layers, conductive layers, and semiconductor layers, which are disposed on the base layer BS, may be formed through coating and deposition processes. Then, the insulating layers, the semiconductor layers, and the conductive layers may be selectively patterned through several photolithography processes. Thus, holes may be defined through the insulating layers or the semiconductor pattern, the conductive pattern, and the signal line may be formed.

The driving element layer DDL may include first, second, third, fourth, fifth, and sixth insulating layers 10, 20, 30, 40, 50, and 60 sequentially stacked on the base layer BS and the pixel driving circuit PDC. FIG. 5 shows one transistor TR and two capacitors C1 and C2 of the pixel driving circuit PDC.

The transistor TR may correspond to a transistor connected to the light emitting element LD via an intermediate connection electrode CN and a connection electrode CNE, i.e., a connection transistor connected to a node (the fourth node N4 of FIG. 2A, the second node N2 of FIG. 2B, or the fourth node N4 of FIG. 2C) corresponding to the cathode of the light emitting element LD. In detail, the transistor TR may correspond to the sixth transistor T6 of FIG. 2A, the first transistor T1 of FIG. 2B, or the fourth transistor T4a of FIG. 2C. Other transistors constituting the pixel driving circuit PDC may have substantially the same structure as that of the transistor TR (hereinafter, referred to as the connection transistor) shown in FIG. 5, however, this is merely an example. Other transistors constituting the pixel driving circuit PDC may have a structure different from the connection transistor TR but are not limited thereto.

The first insulating layer 10 may be disposed on the base layer BS. The first insulating layer 10 may be an inorganic layer and/or an organic layer and may have a single-layer or multi-layer structure. The first insulating layer 10 may include at least one of aluminum oxide, titanium oxide, silicon oxide, silicon nitride, silicon oxynitride, zirconium oxide, and hafnium oxide. The first insulating layer 10 may have a single-layer structure of a silicon oxide layer. Meanwhile, insulating layers described later may be an inorganic layer and/or an organic layer and may have a single-layer or multi-layer structure. The inorganic layer may include at least one of the above-mentioned materials, but is not limited thereto.

Meanwhile, the first insulating layer 10 may cover a lower conductive layer BCL. That is, the display panel DP may further include the lower conductive layer BCL overlapping the connection transistor TR. The lower conductive layer BCL may prevent an electric potential caused by a polarization phenomenon of the base layer BS from affecting the connection transistor TR. In addition, the lower conductive layer BCL may block light incident into the connection transistor TR from a lower side of the lower conductive layer BCL. At least one of an inorganic barrier layer and a buffer layer may be further disposed between the lower conductive layer BCL and the base layer BS.

The lower conductive layer BCL may include a reflective metal material. For example, the lower conductive layer BCL may include titanium (Ti), molybdenum (Mo), an alloy including molybdenum (Mo), aluminum (Al), an alloy including aluminum (Al), aluminum nitride (AlN), tungsten (W), tungsten nitride (WN), and copper (Cu).

The lower conductive layer BCL may be connected to a source of the connection transistor (or the transistor ) TR via a source electrode pattern W1. In this case, the lower conductive layer BCL may be synchronized with the source of the transistor TR, however, this is merely an example. For example, the lower conductive layer BCL may be maintained at the same level as the source of the transistor. The lower conductive layer BCL may be connected to and synchronized with a gate of the transistor TR. The lower conductive layer BCL may be connected to another electrode to independently receive a constant voltage or a pulse signal. The lower conductive layer BCL may be provided in an isolated form isolated from other conductive patterns. The lower conductive layer BCL is not limited to a particular shape since it may be provided in a variety of shapes.

The connection transistor TR may be disposed on the first insulating layer 10. The connection transistor TR may include a semiconductor pattern SP and a gate electrode GE. The semiconductor pattern SP may be disposed on the first insulating layer 10. The semiconductor pattern SP may include an oxide semiconductor. As an example, the oxide semiconductor may include a transparent conductive oxide (TCO), such as indium tin oxide (ITO), indium zinc oxide (IZO), indium gallium zinc oxide (IGZO), zinc oxide (ZnO), indium oxide (In₂O₃), or the like, however, the material for the semiconductor pattern SP is not limited thereto. For example, the semiconductor pattern SP may include amorphous silicon, low temperature polycrystalline silicon, or polycrystalline silicon.

The semiconductor pattern SP may include a source area SR, a drain area DR, and a channel area CR distinguished from each other depending on a degree of conductivity. The channel area CR may overlap the gate electrode GE when viewed from overhead. The source area SR and the drain area DR may be spaced apart from each other with the channel area CR interposed therebetween. When the semiconductor pattern SP is the oxide semiconductor, each of the source area SR and the drain area DR may be a reduced area. Accordingly, the source area SR and the drain area DR may have a relatively high content of reduced metal compared with the channel area CR. According to an embodiment, when the semiconductor pattern SP is the polycrystalline silicon, each of the source area SR and the drain area DR may be a highly doped area.

The source area SR and the drain area DR may have a relatively high conductivity compared with the channel area CR. The source area SR may correspond to a source electrode of the connection transistor TR, and the drain area DR may correspond to a drain electrode of the connection transistor TR. As shown in FIG. 5, the connection transistor TR may further include the source electrode pattern W1 and a drain electrode pattern W2, which are respectively connected to the source area SR and the drain area DR. In detail, each of the source electrode pattern W1 and the drain electrode pattern W2 may be formed as a unified part of one of the lines constituting the pixel driving circuit PDC (refer to FIG. 2A), PDC-1 (refer to FIG. 2B), or PDC-2 (refer to FIG. 2C), but is not limited thereto.

The second insulating layer 20 may commonly overlap the pixels and may cover the semiconductor pattern SP. The second insulating layer 20 may be an inorganic layer and/or an organic layer and may have a single-layer or multi-layer structure. The second insulating layer 20 may include at least one of aluminum oxide, titanium oxide, silicon oxide, silicon nitride, silicon oxynitride, zirconium oxide, and hafnium oxide. The second insulating layer 20 may have a single-layer structure of a silicon oxide layer.

The gate electrode GE may be disposed on the second insulating layer 20. The gate electrode GE may correspond to the gate of the connection transistor TR. In addition, the gate electrode GE may be disposed on the semiconductor pattern SP, however, this is merely an example. The gate electrode GE may be disposed under the semiconductor pattern SP, but is not limited thereto.

The gate electrode GE may include titanium (Ti), silver (Ag), molybdenum (Mo), aluminum (Al), aluminum nitride (AlN), tungsten (W), tungsten nitride (WN), copper (Cu), or an alloy thereof, but is not limited thereto.

The third insulating layer 30 may be disposed on the gate electrode GE. The third insulating layer 30 may be an inorganic layer and/or an organic layer and may have a single-layer or multi-layer structure.

Among conductive patterns W1, W2, CPE1, CPE2, and CPE3, a first capacitor electrode CPE1 and a second capacitor electrode CPE2 may form the first capacitor C1. The first capacitor electrode CPE1 and the second capacitor electrode CPE2 may be spaced apart from each other with the first insulating layer 10 and the second insulating layer 20 interposed therebetween.

The first capacitor electrode CPE1 and the lower conductive layer BCL may be formed as a single integrated unit. In addition, the second capacitor electrode CPE2 and the gate electrode GE formed as a single integrated unit.

A third capacitor electrode CPE3 may be disposed on the third insulating layer 30. The third capacitor electrode CPE3 may be spaced apart from the second capacitor electrode CPE2 with the third insulating layer 30 interposed therebetween and may overlap the second capacitor electrode CPE2 when viewed in from overhead. The third capacitor electrode CPE3 and the second capacitor electrode CPE2 may form the second capacitor C2.

The fourth insulating layer 40 may be disposed on the third insulating layer 30 and/or the third capacitor electrode CPE3. The fourth insulating layer 40 may be an inorganic layer and/or an organic layer and may have a single-layer or multi-layer structure. The fourth insulating layer 40 may include at least one of aluminum oxide, titanium oxide, silicon oxide, silicon nitride, silicon oxynitride, zirconium oxide, and hafnium oxide

The source electrode pattern W1 and the drain electrode pattern W2 may be disposed on the fourth insulating layer 40. The source electrode pattern W1 may be connected to the source area SR of the connection transistor TR via a first contact hole CNT1, and the source electrode pattern W1 and the source area SR of the semiconductor pattern SP may serve as the source of the connection transistor TR. The drain electrode pattern W2 may be connected to the drain area DR of the connection transistor TR via a second contact hole CNT2, and the drain electrode pattern W2 and the drain area DR of the semiconductor pattern SP may serve as a drain of the connection transistor TR. The fifth insulating layer 50 may be disposed on the source electrode pattern W1 and the drain electrode pattern W2.

The intermediate connection electrode CN may be disposed on the fifth insulating layer 50. The intermediate connection electrode CN may electrically connect the pixel driving circuit PDC to the light emitting element LD. That is, the intermediate connection electrode CN may electrically connect the connection transistor TR to the light emitting element LD. The intermediate connection electrode CN is a connection node that connects the pixel driving circuit PDC to the light emitting element LD. That is, the intermediate connection electrode CN may correspond to the fourth node N4 shown in FIG. 2A, may correspond to the second node N2 shown in FIG. 2B, or the fourth node N4 shown in FIG. 2C.

The intermediate connection electrode CN includes a first layer L1, a second layer L2, and a third layer L3, which are sequentially stacked in a third direction DR3. The second layer L2 may include a material different from that of the first layer L1. The second layer L2 may include a material different from that of the third layer L3. The second layer L2 may be thicker than the first layer L1. The second layer L2 may be thicker than the third layer L3. The second layer L2 may include a material with high conductivity. As an example, the second layer L2 may include aluminum (Al).

The sixth insulating layer 60 may be disposed on the intermediate connection electrode CN. The sixth insulating layer 60 may be disposed on the fifth insulating layer 50 and may cover at least a portion of the intermediate connection electrode CN. Each of the fifth insulating layer 50 and the sixth insulating layer 60 may be an organic layer. As an example, each of the fifth insulating layer 50 and the sixth insulating layer 60 may include a general-purpose polymer, such as benzocyclobutene (BCB), polyimide, hexamethyldisiloxane (HMDSO), polymethylmethacrylate (PMMA), or polystyrene (PS), a polymer derivative having a phenolic group, an acrylic-based polymer, an imide-based polymer, an aryl ether-based polymer, an amide-based polymer, and a fluorine-based polymer, a p-xylene-based polymer, a vinyl alcohol-based polymer, or blends thereof.

The sixth insulating layer 60 may have a through hole OP-60 that exposes at least a portion of the intermediate connection electrode CN. A portion of the intermediate connection electrode CN, exposed by not being covered by the sixth insulating layer 60, may be connected to the connection electrode CNE and thus may be electrically connected to the light emitting element LD. That is, the intermediate connection electrode CN and the connection electrode CNE may electrically connect the connection transistor TR and the light emitting element LD. The sixth insulating layer 60 may be omitted or may be provided in plural in the display panel DP, but is not limited thereto. When the sixth insulating layer 60 is omitted, the intermediate connection electrode CN may also be omitted.

Since a lower surface of the connection electrode CNE is in contact with an upper surface of the intermediate connection electrode CN, a contact reliability may be increased. Accordingly, a size of the through hole OP-P required to connect the connection electrode CNE and the intermediate connection electrode CN may be reduced. Accordingly, a size and resolution of the light emitting portion of the display panel DP may be increased.

The light emitting element layer LDL may be disposed on the driving element layer DDL. The light emitting element layer LDL may include the pixel definition layer PDL and the light emitting element LD.

The pixel definition layer PDL may be an organic layer. As an example, the pixel definition layer PDL may include a general-purpose polymer, such as benzocyclobutene (BCB), polyimide, hexamethyldisiloxane (HMDSO), polymethylmethacrylate (PMMA), or polystyrene (PS), a polymer derivative having a phenolic group, an acrylic-based polymer, an imide-based polymer, an aryl ether-based polymer, an amide-based polymer, and a fluorine-based polymer, a p-xylene-based polymer, a vinyl alcohol-based polymer, or blends thereof.

The pixel definition layer PDL may have a light absorbing property. For example, the pixel definition layer PDL may have a black color. That is, the pixel definition layer PDL may include a black coloring agent. The black coloring agent may include a black dye or a black pigment. The black coloring agent may include a metal material, such as carbon black, chromium, or an oxide thereof. The pixel definition layer PDL may correspond to a light blocking pattern having a light blocking property.

The pixel definition layer PDL may include the light emitting opening OP-PDL that exposes at least a portion of the first electrode EL1. The light emitting opening OP-PDL may be provided in plural, and the light emitting openings OP-PDL may respectively correspond to the light emitting elements LD. All components of the light emitting element LD may overlap each other in the light emitting opening OP-PDL, and the light emitting opening OP-PDL may correspond to an area where the light emitted from the light emitting element LD is substantially displayed. Accordingly, the shape of the first light emitting portion EP1 (refer to FIG. 4A) may substantially correspond to the shape of the light emitting opening OP-PDL when viewed from overhead.

The connection electrode CNE may be disposed on the pixel definition layer PDL. The connection electrode CNE may electrically connect the pixel driving circuit PDC and the light emitting element LD. That is, the pixel driving circuit PDC may be electrically connected to the light emitting element LD through the intermediate connection electrode CN and the connection electrode CNE. The connection electrode CNE may correspond to the first connection electrode CNE1 shown in FIG. 4A. The second connection electrode CNE2 (refer to FIG. 4A) and the third connection electrode CNE3 (refer to FIG. 4A) may have a structure similar to the connection electrode CNE.

The connection electrode CNE may include a first edge EG11 that is adjacent to the light emitting opening OP-PDL and a second edge EG12 surrounding the first edge EG11. In an embodiment, the second edge EG12 overlaps the groove GV of the protruding pattern SPR. A second electrode EL2 of the light emitting element LD may be in contact with the connection electrode CNE on an outer side surface OS_SPR of the protruding pattern SPR or in an area adjacent to the outer side surface OS_SPR of the protruding pattern SPR.

The connection electrode CNE may include a transparent conductive oxide (TCO), such as indium tin oxide (ITO), indium zinc oxide (IZO), indium gallium zinc oxide (IGZO), zinc oxide (ZnO), indium oxide (In₂O₃), or the like, but the material for the connection electrode CNE is not limited thereto.

The connection electrode CNE may have a shape surrounding at least a portion of the light emitting portion EP1 (refer to FIG. 4A) defined in the light emitting element LD. Accordingly, the degree of freedom in designing the position where the connection electrode CNE is connected to the light emitting element LD and the degree of freedom in designing the position where the connection electrode CNE is connected to the pixel driving circuit PDC may be increased.

In addition, since the lower surface of the connection electrode CNE is in contact with the upper surface of the intermediate connection electrode CN, the contact reliability may be increased. Thus, the size of the through holes OP-P and OP-60 required to connect the connection electrode CNE and the intermediate connection electrode CN may be reduced. Accordingly, the size and resolution of the light emitting portion of the display panel DP may be increased.

The groove GV may be defined in the protruding pattern SPR. In an embodiment, the groove GV is formed by removing a portion of the protruding pattern SPR from its upper surface U_SPR towards a thickness direction of the protruding pattern SPR, e.g., a direction opposite to the third direction DR3. The groove GV may overlap an area between two connection electrodes CNE adjacent to each other and disposed on the protruding pattern SPR. The second electrode EL2 may be disconnected by the groove GV of the protruding pattern SPR. That is, the groove GV may overlap an area in which the second electrode EL2 is disconnected when viewed from overhead. For example, the groove GV may cut through the second electrode EL2, causing a first section of the second electrode EL2 to be electrically isolated from a second section of the second electrode EL2. This separation may prevent unintended current flow between adjacent regions of the second electrode EL2, enhancing isolation and preventing lateral leakage current.

The through hole OP-P may be defined through the pixel definition layer PDL and may be spaced apart from the light emitting opening OP-PDL. The through hole OP-P may be provided in plural, and the through holes OP-P may be disposed corresponding to the light emitting elements, respectively. In an embodiment, the through hole OP-P defined through the pixel definition layer PDL has a size greater than a size of the through hole OP-60 defined through the sixth insulating layer 60. The connection electrode CNE may be disposed in the through hole OP-P and the through hole OP-60 and may be connected to the intermediate connection electrode CN. That is, the connection electrode CNE may be connected to the pixel driving circuit PDC via the through hole OP-P.

The light emitting element LD may include the first electrode EL1, an intermediate layer IML, and the second electrode EL2.

The first electrode EL1 may be a semi-transmissive electrode, a transmissive electrode, or a reflective electrode. The first electrode EL1 may include a reflective layer formed of silver (Ag), magnesium (Mg), aluminum (Al), platinum (Pt), palladium (Pd), gold (Au), nickel (Ni), neodymium (Nd), iridium (Ir), chromium (Cr), or compounds thereof and a transparent or semi-transparent electrode layer formed on the reflective layer. The transparent or semi-transparent electrode layer may include at least one of indium tin oxide (ITO), indium zinc oxide (IZO), indium gallium zinc oxide (IGZO), zinc oxide (ZnO), indium oxide (In₂O₃), and aluminum-doped zinc oxide (AZO). For instance, the first electrode EL1 may have a stack structure of ITO/Ag/ITO.

The first electrode EL1 may be the anode of the light emitting element LD. That is, the first electrode EL1 may be connected to the first power line VDL (refer to FIG. 2A) and may receive the first power voltage VDD (refer to FIG. 2A). The first electrode EL1 may be connected to the first power line VDL in the display area DA (refer to FIG. 3A or 3B) or may be connected to the first power line VDL in the peripheral area NDA. In the case where the first electrode EL1 is connected to the first power line VDL in the peripheral area NDA, the first power line VDL may be disposed in the peripheral area NDA(refer to FIG. 3A or 3B), and the first electrode EL1 may extend to the peripheral area NDA.

In the cross-sectional view of FIG. 5, the first electrode EL1 overlaps the light emitting opening OP-PDL and does not overlap the groove GV, but is not limited thereto. As described with reference to FIG. 4D, the first electrodes EL1 of the light emitting elements may be constructed as a single integrated unit and may have a mesh or lattice shape in which openings are defined in some areas. That is, the first electrode EL1 may have a variety of shapes as long as the light emitting elements receive the same first power voltage VDD through their first electrodes EL1, but is not limited thereto.

The intermediate layer IML may be disposed between the first electrode EL1 and the second electrode EL2. The intermediate layer IML may include a light emitting layer EML and a functional layer FNL. In an embodiment, a size of the functional layer FNL is greater than that of the light emitting layer EML. The light emitting element LD may include the intermediate layer IML with various structures but is not limited thereto. As an example, the functional layer FNL may include a plurality of layers or may include two or more layers spaced apart from each other with the light emitting layer EML interposed therebetween.

The light emitting layer EML may include an organic light emitting material. The light emitting layer EML may include an inorganic light emitting material or may include a layer obtained by mixing the organic light emitting material with the inorganic light emitting material. In the present embodiment the light emitting layers EML respectively included in the light emitting portions EP (refer to FIG. 3A) adjacent to each other may include light emitting materials displaying different colors from each other. As an example, the light emitting layer EML included in each light emitting portion EP may emit light having at least one of blue, red, and green colors, but is not limited thereto. The light emitting layer EML that is commonly disposed in the light emitting portions EP may include a light emitting material displaying the same color. In this case, the light emitting layer EML may provide a blue light or a white light.

The functional layer FNL may be disposed between the first electrode EL1 and the second electrode EL2. In detail, the functional layer FNL may include a first intermediate functional layer FNL1 disposed between the first electrode EL1 and the light emitting layer EML and a second intermediate functional layer FNL2 disposed between the second electrode EL2 and the light emitting layer EML. One of the first intermediate functional layer FNL1 and the second intermediate functional layer FNL2 may be omitted. The light emitting layer EML may be inserted into the functional layer FNL. That is, the light emitting layer EML may be disposed between the first intermediate functional layer FNL1 and the second intermediate functional layer FNL2.

The functional layer FNL may control a movement of electric charges between the first electrode EL1 and the second electrode EL2. As an example, the first intermediate functional layer FNL1 may include a hole injection/transport material and/or an electron injection/transport material. The second intermediate functional layer FNL2 may include at least one of an electron block layer, a hole transport layer, a hole injection layer, a hole block layer, an electron transport layer, an electron injection layer, and an electric charge generating layer.

The second electrode EL2 may be disposed on the intermediate layer IML. As described above, the second electrode EL2 may be electrically connected to the pixel driving circuit PDC via the connection electrode CNE. The second electrode EL2 may be electrically connected to the connection transistor TR via the connection electrode CNE.

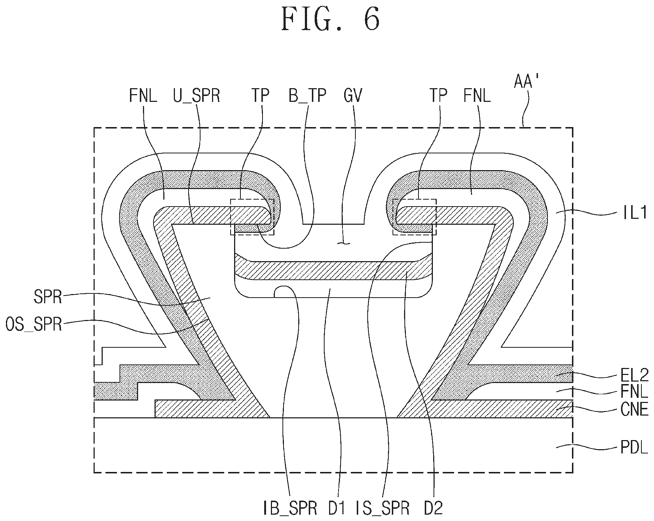

However, the present disclosure is not limited thereto. The encapsulation layer ECL may further include a plurality of inorganic layers and organic layers. As an example, the encapsulation layer ECL may include a first encapsulation layer instead of the first inorganic layer. The first encapsulation layer may include a plurality of sub-encapsulation layers. At least one of the sub-encapsulation layers may include an organic material. As an example, the first encapsulation layer may include a first sub-encapsulation layer, a second sub-encapsulation layer, and a third sub-encapsulation layer, the first and third sub-encapsulation layers may include an inorganic material, and the second sub-encapsulation layer may include the organic material. Even though a gap is formed in the first sub-encapsulation layer that is the inorganic material layer, the gap may be filled by the second sub-encapsulation layer. The first encapsulation layer may smoothly cover the groove GV defined in the protruding pattern SPR and a tip portion TP (refer to FIG. 6) of the connection electrode CNE. For example, the first encapsulation layer may seamlessly extend over the groove GV created in the protruding pattern SPR and the tip portion TP of the connection electrode CNE. Accordingly, a protective function of the encapsulation layer that protects the light emitting element LD may be increased. However, the present disclosure is not limited thereto. For example, the encapsulation layer ECL may be a glass substrate.

The first and second inorganic layers IL1 and IL2 may protect the light emitting element LD from moisture and oxygen outside the display panel DP, and the organic layer OL may protect the light emitting element LD from a foreign substance such as dust particles that remain in a process of forming the first inorganic layer IL1. The first and second inorganic layers IL1 and IL2 may include a silicon nitride layer, a silicon oxynitride layer, a silicon oxide layer, a titanium oxide layer, or an aluminum oxide layer. The organic layer OL may include an acrylic-based organic layer, but is not limited thereto.

The sensing layer ISL may sense external inputs. The sensing layer ISL may be formed on the encapsulation layer ECL through successive processes. In this case, the sensing layer ISL may be disposed directly on the encapsulation layer ECL. In the present disclosure, the expression "The sensing layer ISL is disposed directly on the encapsulation layer ECL" indicates that there are no intervening elements between the sensing layer ISL and the encapsulation layer ECL. That is, a separate adhesive member might not be disposed between the sensing layer ISL and the encapsulation layer ECL, however, this is merely an example. The sensing layer ISL may be provided after being separately formed and may be coupled to the display panel DP by an adhesive member, but is not limited thereto.

The sensing layer ISL may include a plurality of conductive layers and a plurality of insulating layers. The conductive layers may include a first sensing conductive layer MTL1 and a second sensing conductive layer MTL2, and the insulating layers may include first, second, and third sensing insulating layers 71, 72, and 73. However, this is merely an example, and the number of insulating layers is not particularly limited.

Each of the first, second, and third sensing insulating layers 71, 72, and 73 may have a single-layer structure or a multi-layer structure of layers stacked in the third direction DR3. The first, second, and third sensing insulating layers 71, 72, and 73 may include an inorganic layer. The inorganic layer may include at least one of aluminum oxide, titanium oxide, silicon oxide, silicon nitride, silicon oxynitride, zirconium oxide, and hafnium oxide. The first, second, and third sensing insulating layers 71, 72, and 73 may include an organic layer. The organic layer may include at least one of an acrylic-based resin, a methacrylic-based resin, a polyisoprene-based resin, a vinyl-based resin, an epoxy-based resin, a urethane-based resin, a cellulose-based resin, a siloxane-based resin, a polyimide-based resin, a polyamide-based resin, and a perylene-based resin.

The first sensing conductive layer MTL1 may be disposed between the first sensing insulating layer 71 and the second sensing insulating layer 72, and the second sensing conductive layer MTL2 may be disposed between the second sensing insulating layer 72 and the third sensing insulating layer 73. A contact hole CNT formed through the second sensing conductive layer MTL2 may facilitate a connection between a portion of the second sensing conductive layer MTL2 and the first sensing conductive layer MTL1. Each of the first and second sensing conductive layers MTL1 and MTL2 may have a single-layer structure or a multi-layer structure of layers stacked in the third direction DR3.

The sensing conductive layer having the single-layer structure may include a metal layer or a transparent conductive layer. The metal layer may include molybdenum, silver, titanium, copper, aluminum, or alloys thereof. The transparent conductive layer may include a transparent conductive oxide, such as indium tin oxide (ITO), indium zinc oxide (IZO), zinc oxide (ZnO), indium zinc tin oxide (IZTO), or the like. In addition, the transparent conductive layer may include conductive polymer such as PEDOT, metal nanowire, graphene, or the like.

The sensing conductive layer having the multi-layer structure may include metal layers. The metal layers may have a three-layer structure of titanium(Ti)/aluminum(Al)/titanium(Ti). The sensing conductive layer having the multi-layer structure may include at least one metal layer and at least one transparent conductive layer.

The first sensing conductive layer MTL1 and the second sensing conductive layer MTL2 may form a sensor to sense the external inputs in the sensing layer ISL. The sensor may be driven in a capacitive method, e.g., a mutual capacitive method or a self-capacitive method, however, this is merely an example. The sensor may be driven in a resistive film method, an ultrasonic method, or an infrared method rather than the capacitive method, but is not limited thereto.

Each of the first sensing conductive layer MTL1 and the second sensing conductive layer MTL2 may include a transparent conductive oxide or may have a metal mesh shape formed of an opaque conductive material. The first sensing conductive layer MTL1 and the second sensing conductive layer MTL2 may include various materials and various shapes as long as a visibility of the image displayed by the display panel DP is not deteriorated.

FIG. 6 is an enlarged cross-sectional view of an area of the display panel. FIG. 6 shows a cross-section of an area AA' of FIG. 5.

Referring to FIGS. 5 and 6, the protruding pattern SPR may have a reverse-tapered shape. That is, an angle between a lower surface of the protruding pattern SPR and a side surface of the protruding pattern SPR may be an obtuse angle. However, this is merely an example, and the tapered angle is not limited thereto. The tapered angle is flexible, provided that the second electrode EL2 connects to the connection electrode CNE either on the outer side surface OS_SPR of the protruding pattern SPR or in an area adjacent to the outer side surface OS_SPR.

The groove GV may be defined in the protruding pattern SPR. The groove GV may be formed by removing material from the upper surface U_SPR of the protruding pattern SPR downward through its thickness, e.g., in a direction opposite to the third direction DR3. The groove GV may be defined by an inner lower surface IB_SPR of the protruding pattern SPR, inner side surfaces IS_SPR extending from the inner lower surface IB_SPR, and a lower surface B_TP of the tip portion TP of the connection electrode CNE. The groove GV may be formed by etching a portion of the protruding pattern SPR and a portion of the connection electrode CNE after the connection electrode CNE is formed on the protruding pattern SPR.

The connection electrode CNE may extend along the outer side surface OS_SPR and the upper surface U_SPR of the protruding pattern SPR. The connection electrode CNE may include the tip portion TP. As an example, the connection electrode CNE extending along the upper surface U_SPR may include the tip portion TP protruded from an end of the groove GV.

The functional layer FNL may be disposed on the pixel definition layer PDL and the connection electrode CNE. A portion of the functional layer FNL may extend along the outer side surface OS_SPR of the protruding pattern SPR and may be disposed above the protruding pattern SPR. The functional layer FNL extending along an upper portion of the protruding pattern SPR may cover a portion of the tip portion TP of the connection electrode CNE.

The display panel DP may further include a first dummy layer D1 formed in the groove GV of the protruding pattern SPR. The first dummy layer D1 may include the same material as the functional layer FNL and may be formed through the same process as the functional layer FNL. As an example, the first dummy layer D1 may be patterned by the tip portion TP of the connection electrode CNE in a process of depositing the functional layer FNL and may be formed in the groove GV. The first dummy layer D1 may be disposed on the inner lower surface IB_SPR of the protruding pattern SPR and may extend along the inner side surfaces IS_SPR of the protruding pattern SPR. FIG. 6 shows the structure in which the first dummy layer D1 extends along the inner side surfaces IS_SPR of the protruding pattern SPR as a representative example, however, the present disclosure is not limited thereto. As an example, the first dummy layer D1 may be disposed only on the inner lower surface IB_SPR of the protruding pattern SPR according to process conditions.

The second electrode EL2 may be disposed on the functional layer FNL, and the second electrode EL2 may cover a side surface of the functional layer FNL above of the protruding pattern SPR. As an example, the second electrode EL2 may cover the side surface of the functional layer FNL covering the tip portion TP of the connection electrode CNE. In addition, the second electrode EL2 may cover a lower surface B_TP of the tip portion TP of the connection electrode CNE. FIG. 6 shows the structure in which the second electrode EL2 entirely covers the lower surface B_TP of the tip portion TP, but is not limited thereto. For example, the second electrode EL2 may cover only the side surface of the functional layer FNL or may cover only a portion of the lower surface B_TP of the tip portion TP.

The display panel DP may further include a second dummy layer D2 formed in the groove GV of the protruding pattern SPR. The second dummy layer D2 may be composed of the same material and fabricated using the same process as the second electrode EL2. As an example, the second dummy layer D2 may be shaped by the tip portion TP of the connection electrode CNE during the deposition process of the second electrode EL2 and may be positioned within the groove GV. That is, the second electrode EL2 may be disconnected by the groove GV of the protruding pattern SPR. The second electrode EL2 may be disconnected at a position above the protruding pattern SPR rather than a position under the protruding pattern SPR. For example, the groove GV may cut the second electrode EL2 into separate parts. The second dummy layer D2 may be disposed on the first dummy layer D1 and may extend along the inner side surfaces IS_SPR of the protruding pattern SPR. The second dummy layer D2 may be separated from the second electrode EL2.

The second electrode EL2 and the functional layer FNL may be commonly formed in the pixels using an open mask. A portion of the functional layer FNL may include an organic layer. When the organic layer is commonly formed, a lateral leakage current may occur due to the organic layer commonly provided between adjacent pixels, resulting in a color mixture and poor brightness between adjacent pixels. Meanwhile, in the present disclosure, the lateral leakage current may mean a current flowing in a direction intersecting the third direction DR3 other than a current flowing in a stacking direction of the light emitting element, i.e., the direction in which the image is displayed. The lateral leakage current may mean a current flowing in a direction parallel to a plane defined by the first direction DR1 and the second direction DR2.

According to embodiments, the intermediate layer IML and the second electrode EL2 may be separated for each pixel by the tip portion TP of the connection electrode CNE to prevent the lateral leakage current from occurring between adjacent pixels. Accordingly, color mixture between the adjacent pixels and poor brightness may be prevented by preventing the lateral leakage current from occurring. The tip portion TP of the connection electrode CNE may have a closed-line shape with respect to each light emitting portion. Thus, the second electrode EL2 and the functional layer FNL may have a shape divided for each light emitting portion. That is, the second electrode EL2 and the intermediate layer IML may be electrically independent from those in each adjacent pixel.

According to embodiments, since the groove GV is defined in the protruding pattern SPR, the intermediate layer IML (or the functional layer FNL) and the second electrode EL2 may be formed separately for each pixel. Therefore, the lateral leakage current may be prevented from occurring between adjacent pixels, color mixture may be prevented from occurring between adjacent pixels, and poor brightness may be prevented.

Although various embodiments have been described, it is to be understood that the present invention is not limited to these embodiments but various changes and modifications can be made by one ordinary skilled in the art within the scope of the present invention as hereinafter claimed.

## Claims

1. An electronic device comprising:
a pixel driving circuit (PDC) comprising a transistor;
a light emitting element (LD) comprising a first electrode, an intermediate layer disposed on the first electrode, and a second electrode disposed on the intermediate layer;
a connection electrode (CNE) electrically connecting the light emitting element and the pixel driving circuit and comprising a light emitting connection portion (CE1, CE2, CE3) connected to the light emitting element and a driving connection portion (CD3) connected to the pixel driving circuit;
a pixel definition layer (PDL) including a light emitting opening (OP_PDL) defined therethrough and overlapping a portion of the first electrode; and
a protruding pattern disposed on the pixel definition layer, wherein the protruding pattern includes a groove (GV) that extends from an upper surface of the protruding pattern in a thickness direction of the protruding pattern.

2. The electronic device of claim 1, wherein the groove separates the second electrode into two distinct and electrically isolated parts.

3. The electronic device of claim 1 or 2, wherein the connection electrode extends along an outer side surface and an upper surface of the protruding pattern.

4. The electronic device of claim 1, 2 or 3, wherein the connection electrode comprises a first edge and a second edge surrounding the first edge, and the second edge overlaps the groove of the protruding pattern when viewed in a plane.

5. The electronic device of any one of the preceding claims, wherein the connection electrode comprises a tip portion extending from an end of the groove.

6. The electronic device of claim 5, wherein the groove is defined by an inner lower surface of the protruding pattern, inner side surfaces extending from the inner lower surface, and a lower surface of the tip portion of the connection electrode.

7. The electronic device of claim 6, wherein the intermediate layer comprises a light emitting layer and a functional layer, the light emitting layer is disposed between the first electrode and the second electrode, and the functional layer comprises a first intermediate functional layer disposed between the first electrode and the light emitting layer and a second intermediate functional layer disposed between the second electrode and the light emitting layer.

8. The electronic device of claim 7, wherein a portion of the functional layer is disposed on the protruding pattern and covers the tip portion of the connection electrode.

9. The electronic device of claim 8, further comprising a first dummy layer disposed in the groove of the protruding pattern, wherein the first dummy layer comprises the same material as the functional layer and is formed through the same process as the functional layer, optionally wherein the first dummy layer is disposed on the inner lower surface of the protruding pattern, and extends along the inner side surfaces of the protruding pattern.

10. The electronic device of claim 9, wherein the second electrode is disposed on the functional layer at a position above the protruding pattern, and the second electrode covers a side surface of the functional layer.

11. The electronic device of claim 10, wherein the second electrode covers the lower surface of the tip portion of the connection electrode.

12. The electronic device of claim 10 or 11, further comprising a second dummy layer disposed in the groove of the protruding pattern, wherein the second dummy layer comprises the same material as the second electrode and is formed through the same process as the second electrode, optionally wherein the second dummy layer is disposed on the first dummy layer and extends along the inner side surfaces of the protruding pattern.

13. The electronic device of any one of the preceding claims, wherein the second electrode is connected to the connection electrode on an outer side surface of the protruding pattern or in an area adjacent to the outer side surface of the protruding pattern.

14. The electronic device of any one of the preceding claims, wherein the protruding pattern has a reverse-tapered shape.

15. The electronic device of any one of the preceding claims, further comprising an intermediate connection electrode electrically connecting the pixel driving circuit and the connection electrode,
wherein the pixel definition layer includes a through hole, and the connection electrode is connected to the intermediate connection electrode and the pixel driving circuit via the through hole.
